(19)

Europäisches
Patentamt
European
Patent Office
Office européen
des brevets

(11) **EP 4 564 353 A1**

(12) **EUROPEAN PATENT APPLICATION**
published in accordance with Art. 153(4) EPC

(43) Date of publication:
**04.06.2025 Bulletin 2025/23**

(21) Application number: **23849143.5**

(22) Date of filing: **30.06.2023**

(51) International Patent Classification (IPC):
**G11C 11/22** *(2006.01)*

(52) Cooperative Patent Classification (CPC):
**G11C 5/14; G11C 11/22**

(86) International application number:
**PCT/CN2023/105339**

(87) International publication number:
**WO 2024/027433 (08.02.2024 Gazette 2024/06)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **02.08.2022 CN 202210921113**

(71) Applicant: **Huawei Technologies Co., Ltd.
Shenzhen, Guangdong 518129 (CN)**

(72) Inventors:
• **TAN, Wanliang
Shenzhen, Guangdong 518129 (CN)**
• **CAI, Jialin
Shenzhen, Guangdong 518129 (CN)**
• **XU, Jeffrey Junhao
Shenzhen, Guangdong 518129 (CN)**

(74) Representative: **Grünecker Patent- und
Rechtsanwälte
PartG mbB
Leopoldstraße 4
80802 München (DE)**

(54) **INTEGRATED CIRCUIT AND CONTROL METHOD THEREFOR, AND CHIP AND TERMINAL**

(57) This application provides an integrated circuit and a control method thereof, a chip, and a terminal, to prolong endurance of a ferroelectric capacitor. The integrated circuit includes a ferroelectric memory unit, a comparison circuit, and a control circuit. The ferroelectric memory unit writes a first digital signal in a write phase, writes a second digital signal in a read phase, and inputs, to the comparison circuit, a target voltage obtained by switching a polarization state. The comparison circuit compares the target voltage with a reference voltage, and if the target voltage is greater than the reference voltage, inputs a first comparison result to the control circuit. The control circuit controls the ferroelectric memory unit to repeat the write phase and the read phase, gradually decreases a read pulse width and/or a read voltage of the read phase until a second comparison result input by the comparison circuit indicating that the target voltage is less than or equal to the reference voltage is received, and selects a read pulse width and/or a read voltage previous to reception of the second comparison result for the first time as a read pulse width and/or a read voltage of the read phase.

FIG. 4a

## Description

This application claims priority to Chinese Patent Application No. 202210921113.X, filed with the China National Intellectual Property Administration on August 2, 2022 and entitled "INTEGRATED CIRCUIT AND CONTROL METHOD THEREOF, CHIP, AND TERMINAL", which is incorporated herein by reference in its entirety.

## TECHNICAL FIELD

This application relates to the field of memory technologies, and in particular, to an integrated circuit and a control method thereof, a chip, and a terminal.

## BACKGROUND

Ferroelectric memory devices have advantages such as low read/write voltages, low power consumption, small device sizes, high read/write speeds, good cycle performance, radiation resistance, and non-volatility, and are expected to be used to construct next-generation memory chips. A thickness of a ferroelectric functional layer of a hafnium-oxide-based ferroelectric memory device may be reduced to 10 nanometers or even sub-10 nanometers, so that high-density integration or even three-dimensional integration can be implemented, and the hafnium-oxide-based ferroelectric memory device has a unique advantage in constructing an ultra-high-density memory chip.

However, due to poor endurance (endurance) of the hafnium-oxide-based ferroelectric memory device, it is difficult to maintain good ferroelectric performance after a plurality of program/erase cycles. Therefore, the hafnium-oxide-based ferroelectric memory device cannot be widely used in commercial memories.

## SUMMARY

This application provides an integrated circuit and a control method thereof, a chip, and a terminal, to prolong endurance of a ferroelectric capacitor by reducing remnant polarization of the ferroelectric capacitor.

According to a first aspect, this application provides an integrated circuit. The integrated circuit includes a ferroelectric memory unit, a comparison circuit, and a control circuit. The ferroelectric memory unit is configured to: write a first digital signal in a write phase, write a second digital signal in a read phase, switch a polarization state of the ferroelectric memory unit in the read phase, to obtain a target voltage, and input the target voltage to the comparison circuit, where the first digital signal is different from the second digital signal. The comparison circuit is configured to: compare the target voltage with a reference voltage, and if the target voltage is greater than the reference voltage, input a first comparison result to the control circuit. The control circuit is configured to: receive the first comparison result, control the ferroelectric memory unit to repeat the write phase and the read phase, gradually decrease a read pulse width and/or a read voltage of the read phase until a second comparison result input by the comparison circuit indicating that the target voltage is less than or equal to the reference voltage is received, and select a read pulse width and/or a read voltage previous to reception of the second comparison result for the first time as a read pulse width and/or a read voltage of the read phase.

In this application, it can be learned according to the formula Q=2PrAMFM that remnant polarization is positively correlated with a total quantity of charges read in the read phase, and the read voltage and the read pulse width of the read phase determine the total quantity of charges read in the read phase. Therefore, in this application, endurance of a ferroelectric capacitor may be prolonged by adjusting the read voltage and the read pulse width of the read phase.

For example, the first digital signal is 1 and the second digital signal is 0. The first digital signal 1 may be first written, and then a read operation is performed based on the read voltage and the read pulse width, to write the second digital signal 0. After being enabled, the comparison circuit compares the received target voltage with the reference voltage, and then inputs a first comparison result 1 to the control circuit. To avoid damage to the ferroelectric capacitor due to excessively high remnant polarization resulting from the current read voltage and the current read pulse width, the first digital signal 1 continues to be written, and the control circuit controls the read voltage to decrease, and/or the control circuit controls the read pulse width to decrease, to perform a read operation and write the second digital signal 0. If the comparison circuit inputs a second comparison result 0 to the control circuit, the previous read voltage and the previous read pulse width are selected as the read voltage and the read pulse width of the read phase; and if the comparison circuit still inputs the first comparison result 1 to the control circuit, the foregoing write and read operations are still repeated, and the control circuit controls the read voltage and/or the read pulse width to gradually decrease until the comparison circuit inputs the second comparison result 0 to the control circuit, and selects, as the read voltage and the read pulse width of the read phase, the read voltage and the read pulse width previous to outputting the second comparison result 0 by the comparison circuit. In this way, the read voltage and the read pulse width of the read phase can ensure that there are enough charges participating in ferroelectric polarization state switching, and that the remnant polarization is enough to write 0 in the read phase. This can further avoid excessively large remnant polarization caused by an excessively high read voltage and/or an excessively large read pulse width. Therefore, the ferroelectric capacitor is not damaged, and endurance of the ferroelectric capacitor is not affected.

In some possible implementations, the comparison circuit is further configured to: input the second comparison result to the control circuit when the target voltage is greater than the reference voltage. The control circuit is further configured to: receive the second comparison result, control the ferroelectric memory unit to repeat the write phase and the read phase, gradually increase the read pulse width and/or the read voltage of the read phase until the first comparison result input by the comparison circuit is received, and select, as a read pulse width and/or a read voltage of the read phase, a read pulse width and/or a read voltage upon reception of the first comparison result for the first time.

For example, the first digital signal is still 1 and the second digital signal is still 0. Upon detection of whether reading is sufficient in the read phase, the comparison circuit may further output the second comparison result 0 for the first time, to indicate that there are not enough charges participating in ferroelectric polarization state switching, and that the remnant polarization is not enough to write the second digital signal 0 in the read phase. In this case, the read voltage and the read pulse width of the read phase may also be adjusted. The remnant polarization of the ferroelectric capacitor is improved, to ensure that the ferroelectric capacitor can work normally. In addition, the ferroelectric capacitor is not damaged due to excessively high remnant polarization of the ferroelectric capacitor.

For example, the first digital signal 1 may be first written, and then a read operation is performed based on the read voltage and the read pulse width, to write the second digital signal 0. After being enabled, the comparison circuit compares the received target voltage with the reference voltage, and then inputs the second comparison result 0 to the control circuit. Then, the ferroelectric capacitor can work normally, and the first digital signal 1 continues to be written. The control circuit controls the read voltage to increase, and/or the control circuit controls the read pulse width to increase, to perform a read operation and write the second digital signal 0. If the comparison circuit inputs the first comparison result 1 to the control circuit, the current read voltage and the current read pulse width are selected as the read voltage and the read pulse width of the read phase; and if the comparison circuit still inputs the second comparison result 0 to the control circuit, the foregoing write and read operations are still repeated, and the control circuit controls the read voltage and/or the read pulse width to gradually increase until the comparison circuit inputs the first comparison result 1 to the control circuit, and selects, as a read voltage and a read pulse width of the read phase, a read voltage and a read pulse width upon outputting the first comparison result 1 for the first time by the comparison circuit. In this way, this can ensure that the ferroelectric capacitor meets a storage function, and can further ensure that there are enough charges participating in ferroelectric polarization state switching, and that the remnant polarization is enough to write 0 in the read phase. This avoids the excessively large remnant polarization caused by the excessively high read voltage and/or the excessively large read pulse width. Therefore, the ferroelectric capacitor is not damaged, and endurance of the ferroelectric capacitor is not affected.

In some possible implementations, the ferroelectric memory unit includes a transistor and the ferroelectric capacitor, and the integrated circuit further includes a word line, a bit line, and a plate line. The word line is electrically connected to a gate of the transistor, the bit line is electrically connected to a first electrode of the transistor, and the plate line is electrically connected to a second electrode of the transistor. Potentials of the word line, the bit line, and the plate line may be controlled to write the first digital signal into the ferroelectric memory unit in the write phase and write the second digital signal into the ferroelectric memory unit in the read phase.

In a case, the first digital signal is 1, and the second digital signal is 0. The bit line is further electrically connected to an input end of the comparison circuit. When the transistor is conducted, if the bit line is at a high level and the plate line is at a low level, the ferroelectric capacitor is configured to write the first digital signal in the write phase; and if the plate line is at a high level and the bit line is at a low level, the ferroelectric capacitor is configured to write the second digital signal in the read phase.

In this case, the integrated circuit further includes a first capacitor, and the first capacitor is electrically connected to the input end of the comparison circuit and the bit line. The first capacitor is configured to: receive a charge released when polarization of the ferroelectric capacitor is switched, and output the received charge as the target voltage. When the integrated circuit works, the first capacitor is configured to receive and store the charge released when polarization of the ferroelectric capacitor is switched. When the comparison circuit is enabled, the first capacitor inputs the stored charge to the comparison circuit in a voltage form. In other words, the first capacitor inputs the target voltage to the comparison circuit. The target voltage may be a voltage change value of the plate line after removing of a voltage on the bit line.

In another case, the first digital signal is 0, and the second digital signal is 1. The plate line is further electrically connected to an input end of the comparison circuit. When the transistor is conducted, if the plate line is at a high level and the bit line is at a low level, the ferroelectric capacitor is configured to write the first digital signal in the write phase; and if the bit line is at a high level and the plate line is at a low level, the ferroelectric capacitor is configured to write the second digital signal in the read phase.

In this case, the integrated circuit further includes a second capacitor, and the second capacitor is electrically connected to the input end of the comparison circuit and the plate line. The second capacitor is configured to: receive a charge released when polarization of the ferroelectric capacitor is switched, and output the received charge as the target voltage. The second capacitor is configured to receive and store the charge released when polarization of the ferroelectric capacitor is switched. When the comparison circuit is enabled, the second capacitor inputs the stored charge to the comparison circuit in a voltage form. In other words, the second capacitor inputs the target voltage to the comparison circuit. The target voltage may be a voltage change value of the plate line after removing of a voltage on the bit line.

According to a second aspect, this application provides an integrated circuit. The integrated circuit includes a ferroelectric memory unit, a comparison circuit, and a control circuit. The ferroelectric memory unit is configured to: sequentially write a second digital signal and a first digital signal in a write phase, write the second digital signal in a read phase, switch a polarization state of the ferroelectric memory unit in the read phase, to obtain a target voltage, and input the target voltage to the comparison circuit, where the first digital signal is different from the second digital signal. The comparison circuit is configured to: compare the target voltage with a reference voltage, and if the target voltage is greater than the reference voltage, input a first comparison result to the control circuit. The control circuit is configured to: receive the first comparison result, control the ferroelectric memory unit to repeat the write phase and the read phase, gradually decrease, until a second comparison result input by the comparison circuit indicating that the target voltage is less than or equal to the reference voltage is received, a write pulse width and/or a write voltage for writing the first digital signal in the write phase, and select a write pulse width and/or a write voltage previous to reception of the second comparison result for the first time as a write pulse width and/or a write voltage for writing the first digital signal in the write phase.

In this application, it can be learned according to the formula Q=2PrAMFM that remnant polarization is positively correlated with a total quantity of charges read in the read phase, and the write pulse width and/or the write voltage for writing the first digital signal in the write phase determine a total quantity of charges generated when the first digital signal is written in the write phase. Therefore, in this embodiment of this application, the write voltage and the write pulse width for writing the first digital signal in the write phase may be adjusted, to prolong endurance of the ferroelectric capacitor.

For example, the first digital signal is 1, and the second digital signal is 0. The second digital signal 0 and the first digital signal 1 may be sequentially written. Then, the second digital signal 0 is written in the read phase. After being enabled, the comparison circuit compares the received target voltage with the reference voltage, and then inputs the first comparison result 1 to the control circuit. To avoid damage to the ferroelectric capacitor due to excessively high remnant polarization resulting from the current write voltage and the current write pulse width for writing the first digital signal 1, the second digital signal 0 and the first digital signal 1 continue to be sequentially written in the write phase, and the control circuit controls the write voltage for writing the first digital signal 1 to decrease; and/or the control circuit controls the write pulse width for writing the first digital signal 1 to decrease, to perform a write operation of writing the first digital signal 1. If the comparison circuit inputs a second comparison result 0 to the control circuit, the previous write voltage and the previous write pulse width are selected as the write voltage and the write pulse width for writing the first digital signal 1 in the write phase; and if the comparison circuit still inputs the first comparison result 1 to the control circuit, the foregoing write and read operations are still repeated, and the control circuit controls the write voltage and/or the write pulse width to gradually decrease until the comparison circuit inputs the second comparison result 0 to the control circuit, and selects, as the write voltage and the write pulse width for writing the first digital signal 1 in the write phase, the write voltage and/or the write pulse width previous to outputting the second comparison result 0 by the comparison circuit 0.

In this way, the write voltage and the write pulse width for writing the first digital signal in the write phase can ensure that there are enough charges participating in ferroelectric polarization state switching, and that the remnant polarization is enough to write 0 in the read phase. This can further avoid excessively large remnant polarization caused by an excessively large write voltage and/or an excessively large write pulse width. Therefore, the ferroelectric capacitor is not damaged, and endurance of the ferroelectric capacitor is not affected.

In some possible implementations, the comparison circuit is further configured to: input the second comparison result to the control circuit when the target voltage is greater than the reference voltage. The control circuit is further configured to: receive the second comparison result, control the ferroelectric memory unit to repeat the write phase and the read phase, gradually increase, until the first comparison result input by the comparison circuit is received, the write pulse width and/or the write voltage for writing the first digital signal in the write phase, and select, as a write pulse width and/or a write voltage for writing the first digital signal in the write phase, a write pulse width and/or a write voltage upon reception of the first comparison result for the first time.

For example, the first digital signal is still 1 and the second digital signal is still 0. Upon detection of whether writing is sufficient in the write phase, the comparison circuit may further output the second comparison result 0 for the first time, to indicate that there are not enough charges participating in ferroelectric polarization state switching, and that the remnant polarization is not enough to write the first digital signal 1 in the write phase. In this case, the write voltage and the write pulse width for writing the first digital signal 1 in the write phase may also be adjusted. The remnant polarization of the ferroelectric capacitor is improved, to ensure that the ferroelectric capacitor can work normally. In addition, the ferroelectric capacitor is not damaged due to excessively high remnant polarization of the ferroelectric capacitor.

For example, the second digital signal 0 may be first written, and then the first digital signal 1 is written. Then, the second digital signal 0 is written in the read phase. After being enabled, the comparison circuit compares the received target voltage with the reference voltage, and then inputs the second comparison result 0 to the control circuit. Then, the ferroelectric capacitor can work normally, and the first digital signal 1 continues to be written. The control circuit controls the write voltage for writing the first digital signal 1 to increase, and/or the control circuit controls the write pulse width for writing the first digital signal 1 to increase, to perform a write operation of writing the first digital signal 1. If the comparison circuit inputs the first comparison result 1 to the control circuit, the current write voltage and the current write pulse width are selected as the write voltage and the write pulse width for writing the first digital signal 1 in the write phase; and if the comparison circuit still inputs the second comparison result 0 to the control circuit, the foregoing write and read operations are still repeated, and the control circuit controls the write voltage and/or the write pulse width to gradually increase until the comparison circuit inputs the first comparison result 1 to the control circuit, and selects, as a write voltage and a write pulse width for writing the first digital signal 1 in the write phase, a write voltage and a write pulse width upon outputting the first comparison result 1 for the first time by the comparison circuit.

In some possible implementations, the ferroelectric memory unit includes a transistor and a ferroelectric capacitor, and the integrated circuit further includes a word line, a bit line, and a plate line. The word line is electrically connected to a gate of the transistor, the bit line is electrically connected to a first electrode of the transistor, and the plate line is electrically connected to a second electrode of the transistor. Potentials of the word line, the bit line, and the plate line may be controlled to write the first digital signal into the ferroelectric memory unit in the write phase and write the second digital signal into the ferroelectric memory unit in the read phase.

In a case, the first digital signal is 1, and the second digital signal is 0. The bit line is further electrically connected to an input end of the comparison circuit. When the transistor is conducted, if the plate line is at a high level and the bit line is at a low level, the ferroelectric capacitor is configured to write the second digital signal in the write phase and the read phase; and if the bit line is at a high level and the plate line is at a low level, the ferroelectric capacitor is configured to write the first digital signal in the write phase.

In this case, the integrated circuit further includes a first capacitor, and the first capacitor is electrically connected to the input end of the comparison circuit and the bit line. The first capacitor is configured to: receive a charge released when polarization of the ferroelectric capacitor is switched, and output the received charge as the target voltage. When the integrated circuit works, the first capacitor is configured to receive and store the charge released when polarization of the ferroelectric capacitor is switched. When the comparison circuit is enabled, the first capacitor inputs the stored charge to the comparison circuit in a voltage form. In other words, the first capacitor inputs the target voltage to the comparison circuit. The target voltage may be a voltage change value of the plate line after removing of a voltage on the bit line.

In another case, the first digital signal is 0, and the second digital signal is 1. The plate line is further electrically connected to an input end of the comparison circuit. When the transistor is conducted, if the bit line is at a high level and the plate line is at a low level, the ferroelectric capacitor is configured to write the second digital signal in the write phase and the read phase; and if the plate line is at a high level and the bit line is at a low level, the ferroelectric capacitor is configured to write the first digital signal in the write phase.

In this case, the integrated circuit further includes a second capacitor, and the second capacitor is electrically connected to the input end of the comparison circuit and the plate line. The second capacitor is configured to: receive a charge released when polarization of the ferroelectric capacitor is switched, and output the received charge as the target voltage. The second capacitor is configured to receive and store the charge released when polarization of the ferroelectric capacitor is switched. When the comparison circuit is enabled, the second capacitor inputs the stored charge to the comparison circuit in a voltage form. In other words, the second capacitor inputs the target voltage to the comparison circuit. The target voltage may be a voltage change value of the plate line after removing of a voltage on the bit line.

According to a third aspect, this application provides a chip, including the integrated circuit according to the first aspect or the second aspect.

The third aspect and any implementation of the third aspect separately correspond to the first aspect and any implementation of the first aspect and the second aspect and any implementation of the second aspect. For technical effects corresponding to the third aspect and any implementation of the third aspect, refer to technical effects corresponding to the first aspect, any implementation of the first aspect, the second aspect, and any implementation of the second aspect. Details are not described herein again.

According to a fourth aspect, this application provides a terminal. The terminal includes a circuit board and the chip according to the third aspect, and the chip is disposed on the circuit board.

The fourth aspect and any implementation of the fourth aspect separately correspond to the first aspect and any implementation of the first aspect and the second aspect and any implementation of the second aspect. For technical effects corresponding to the fourth aspect and any implementation of the fourth aspect, refer to technical effects corresponding to the first aspect, any implementation of the first aspect, the second aspect, and any implementation of the second aspect. Details are not described herein again.

According to a fifth aspect, this application provides a control method of an integrated circuit. The integrated circuit includes a ferroelectric memory unit, a comparison circuit, and a control circuit. The control method of the integrated circuit includes: writing, by the ferroelectric memory unit, a first digital signal in a write phase, writing a second digital signal in a read phase, and switching a polarization state of the ferroelectric memory unit in the read phase, to obtain a target voltage, and inputting, by the ferroelectric memory unit, the target voltage to the comparison circuit, where the first digital signal is different from the second digital signal; comparing, by the comparison circuit, the target voltage with a reference voltage, and if the target voltage is greater than the reference voltage, inputting, by the comparison circuit, a first comparison result to the control circuit; and receiving, by the control circuit, the first comparison result, controlling the ferroelectric memory unit to repeat the write phase and the read phase, gradually decreasing a read pulse width and/or a read voltage of the read phase until the control circuit receives a second comparison result input by the comparison circuit indicating that the target voltage is less than or equal to the reference voltage, and selecting a read pulse width and/or a read voltage previous to reception of the second comparison result for the first time as a read pulse width and/or a read voltage of the read phase.

In this application, it can be learned according to the formula Q=2PrAMFM that remnant polarization is positively correlated with a total quantity of charges read in the read phase, and the read voltage and the read pulse width of the read phase determine the total quantity of charges read in the read phase. Therefore, in this application, endurance of the ferroelectric capacitor may be prolonged by adjusting the read voltage and the read pulse width of the read phase.

For example, the first digital signal is 1 and the second digital signal is 0. The first digital signal 1 may be first written, and then a read operation is performed based on the read voltage and the read pulse width, to write the second digital signal 0. After being enabled, the comparison circuit compares the received target voltage with the reference voltage, and then inputs the first comparison result 1 to the control circuit. To avoid damage to the ferroelectric capacitor due to excessively high remnant polarization resulting from the current read voltage and the current read pulse width, the first digital signal 1 continues to be written, and the control circuit controls the read voltage to decrease, and/or the control circuit controls the read pulse width to decrease, to perform a read operation and write the second digital signal 0. If the comparison circuit inputs the second comparison result 0 to the control circuit, the previous read voltage and the previous read pulse width are selected as the read voltage and the read pulse width of the read phase; and if the comparison circuit still inputs the first comparison result 1 to the control circuit, the foregoing write and read operations are still repeated, and the control circuit controls the read voltage and/or the read pulse width to gradually decrease until the comparison circuit inputs the second comparison result 0 to the control circuit, and selects, as the read voltage and the read pulse width of the read phase, the read voltage and the read pulse width previous to outputting the second comparison result 0 by the comparison circuit. In this way, the read voltage and the read pulse width of the read phase can ensure that there are enough charges participating in ferroelectric polarization state switching, and that the remnant polarization is enough to write 0 in the read phase. This can further avoid excessively large remnant polarization caused by an excessively high read voltage and/or an excessively large read pulse width. Therefore, the ferroelectric capacitor is not damaged, and endurance of the ferroelectric capacitor is not affected.

In some possible implementations, after the inputting the target voltage to the comparison circuit, the control method of the integrated circuit further includes: comparing, by the comparison circuit, the target voltage with the reference voltage, and if the target voltage is less than or equal to the reference voltage, inputting, by the comparison circuit, the second comparison result to the control circuit; and receiving, by the control circuit, the second comparison result, controlling the ferroelectric memory unit to repeat the write phase and the read phase, gradually increasing the read pulse width and/or the read voltage of the read phase until the control circuit receives the first comparison result input by the comparison circuit, and selecting, as a read pulse width and/or a read voltage of the read phase, a read pulse width and/or a read voltage upon reception of the first comparison result for the first time.

For example, the first digital signal is still 1 and the second digital signal is still 0. Upon detection of whether reading is sufficient in the read phase, the comparison circuit may further output the second comparison result 0 for the first time, to indicate that there are not enough charges participating in ferroelectric polarization state switching, and that the remnant polarization is not enough to write the second digital signal 0 in the read phase. In this case, the read voltage and the read pulse width of the read phase may also be adjusted. The remnant polarization of the ferroelectric capacitor is improved, to ensure that the ferroelectric capacitor can work normally. In addition, the ferroelectric capacitor is not damaged due to excessively high remnant polarization of the ferroelectric capacitor.

For example, the first digital signal 1 may be first written, and then a read operation is performed based on the read voltage and the read pulse width, to write the second digital signal 0. After being enabled, the comparison circuit compares the received target voltage with the reference voltage, and then inputs the second comparison result 0 to the control circuit. Then, the ferroelectric capacitor can work normally, and the first digital signal 1 continues to be written. The control circuit controls the read voltage to increase, and/or the control circuit controls the read pulse width to increase, to perform a read operation and write the second digital signal 0. If the comparison circuit inputs the first comparison result 1 to the control circuit, the current read voltage and the current read pulse width are selected as the read voltage and the read pulse width of the read phase; and if the comparison circuit still inputs the second comparison result 0 to the control circuit, the foregoing write and read operations are still repeated, and the control circuit controls the read voltage and/or the read pulse width to gradually increase until the comparison circuit inputs the first comparison result 1 to the control circuit, and selects, as a read voltage and a read pulse width of the read phase, a read voltage and a read pulse width upon outputting the first comparison result 1 for the first time by the comparison circuit. In this way, this can ensure that the ferroelectric capacitor meets a storage function, and can further ensure that there are enough charges participating in ferroelectric polarization state switching, and that the remnant polarization is enough to write 0 in the read phase. This avoids the excessively large remnant polarization caused by the excessively high read voltage and/or the excessively large read pulse width. Therefore, the ferroelectric capacitor is not damaged, and endurance of the ferroelectric capacitor is not affected.

According to a sixth aspect, this application provides a control method of an integrated circuit. The integrated circuit includes a ferroelectric memory unit, a comparison circuit, and a control circuit. The control method of the integrated circuit includes: sequentially writing, by the ferroelectric memory unit, a second digital signal and a first digital signal in a write phase, writing the second digital signal in a read phase, and switching a polarization state of the ferroelectric memory unit in the read phase, to obtain a target voltage, and inputting, by the ferroelectric memory unit, the target voltage to the comparison circuit, where the first digital signal is different from the second digital signal; comparing, by the comparison circuit, the target voltage with a reference voltage, and if the target voltage is greater than the reference voltage, inputting, by the comparison circuit, a first comparison result to the control circuit; and receiving, by the control circuit, the first comparison result, controlling the ferroelectric memory unit to repeat the write phase and the read phase, gradually decreasing, until the control circuit receives a second comparison result input by the comparison circuit indicating that the target voltage is less than or equal to the reference voltage, a write pulse width and/or a write voltage for writing the first digital signal in the write phase, and selecting a write pulse width and/or a write voltage previous to reception of the second comparison result for the first time as a write pulse width and/or a write voltage for writing the first digital signal in the write phase.

In this application, it can be learned according to the formula Q=2PrAMFM that remnant polarization is positively correlated with a total quantity of charges read in the read phase, and the write pulse width and/or the write voltage for writing the first digital signal in the write phase determine a total quantity of charges generated when the first digital signal is written in the write phase. Therefore, in this embodiment of this application, the write voltage and the write pulse width for writing the first digital signal in the write phase may be adjusted, to prolong endurance of the ferroelectric capacitor.

For example, the first digital signal is 1, and the second digital signal is 0. The second digital signal 0 and the first digital signal 1 may be sequentially written. Then, the second digital signal 0 is written in the read phase. After being enabled, the comparison circuit compares the received target voltage with the reference voltage, and then inputs the first comparison result 1 to the control circuit. To avoid damage to the ferroelectric capacitor due to excessively high remnant polarization resulting from the current write voltage and the current write pulse width for writing the first digital signal 1, the second digital signal 0 and the first digital signal 1 continue to be sequentially written in the write phase, and the control circuit controls the write voltage for writing the first digital signal 1 to decrease; and/or the control circuit controls the write pulse width for writing the first digital signal 1 to decrease, to perform a write operation of writing the first digital signal 1. If the comparison circuit inputs the second comparison result 0 to the control circuit, the previous write voltage and the previous write pulse width are selected as the write voltage and the write pulse width for writing the first digital signal 1 in the write phase; and if the comparison circuit still inputs the first comparison result 1 to the control circuit, the foregoing write and read operations are still repeated, and the control circuit controls the write voltage and/or the write pulse width to gradually decrease until the comparison circuit inputs the second comparison result 0 to the control circuit, and selects, as the write voltage and the write pulse width for writing the first digital signal 1 in the write phase, the write voltage and/or the write pulse width previous to outputting the second comparison result 0 by the comparison circuit 0.

In this way, the write voltage and the write pulse width for writing the first digital signal in the write phase can ensure that there are enough charges participating in ferroelectric polarization state switching, and that the remnant polarization is enough to write 0 in the read phase. This can further avoid excessively large remnant polarization caused by an excessively large write voltage and/or an excessively large write pulse width. Therefore, the ferroelectric capacitor is not damaged, and endurance of the ferroelectric capacitor is not affected.

In some possible implementations, after the inputting the target voltage to the comparison circuit, the control method of the integrated circuit further includes: comparing, by the comparison circuit, the target voltage with the reference voltage, and if the target voltage is less than or equal to the reference voltage, inputting, by the comparison circuit, the second comparison result to the control circuit; and receiving, by the control circuit, the second comparison result, controlling the ferroelectric memory unit to repeat the write phase and the read phase, gradually increasing, until the control circuit receives the first comparison result input by the comparison circuit, the write pulse width and/or the write voltage for writing the first digital signal in the write phase, and selecting, as a write pulse width and/or a write voltage for writing the first digital signal in the write phase, a write pulse width and/or a write voltage upon reception of the first comparison result for the first time.

For example, the first digital signal is still 1 and the second digital signal is still 0. Upon detection of whether writing is sufficient in the write phase, the comparison circuit may further output the second comparison result 0 for the first time, to indicate that there are not enough charges participating in ferroelectric polarization state switching, and that the remnant polarization is not enough to write the first digital signal 1 in the write phase. In this case, the write voltage and the write pulse width for writing the first digital signal 1 in the write phase may also be adjusted. The remnant polarization of the ferroelectric capacitor is improved, to ensure that the ferroelectric capacitor can work normally. In addition, the ferroelectric capacitor is not damaged due to excessively high remnant polarization of the ferroelectric capacitor.

For example, the second digital signal 0 may be first written, and then the first digital signal 1 is written. Then, the second digital signal 0 is written in the read phase. After being enabled, the comparison circuit compares the received target voltage with the reference voltage, and then inputs the second comparison result 0 to the control circuit. Then, the ferroelectric capacitor can work normally, and the first digital signal 1 continues to be written. The control circuit controls the write voltage for writing the first digital signal 1 to increase, and/or the control circuit controls the write pulse width for writing the first digital signal 1 to increase, to perform a write operation of writing the first digital signal 1. If the comparison circuit inputs the first comparison result 1 to the control circuit, the current write voltage and the current write pulse width are selected as the write voltage and the write pulse width for writing the first digital signal 1 in the write phase; and if the comparison circuit still inputs the second comparison result 0 to the control circuit, the foregoing write and read operations are still repeated, and the control circuit controls the write voltage and/or the write pulse width to gradually increase until the comparison circuit inputs the first comparison result 1 to the control circuit, and selects, as a write voltage and a write pulse width for writing the first digital signal 1 in the write phase, a write voltage and a write pulse width upon outputting the first comparison result 1 for the first time by the comparison circuit.

BRIEF DESCRIPTION OF DRAWINGS

FIG. 1 is a connection diagram of structures in a terminal according to an embodiment of this application;
FIG. 2 is a curve diagram of a relationship between remnant polarization and a quantity of program/erase cycles according to a related technology;
FIG. 3a is a circuit diagram of an integrated circuit according to an embodiment of this application;
FIG. 3b is another circuit diagram of an integrated circuit according to an embodiment of this application;
FIG. 4a is a working timing diagram of an integrated circuit according to an embodiment of this application;
FIG. 4b is another working timing diagram of an integrated circuit according to an embodiment of this application;
FIG. 4c is a diagram of comparison between quantities of program/erase cycles according to an embodiment of this application;
FIG. 5a is still another working timing diagram of an integrated circuit according to an embodiment of this application;
FIG. 5b is still another working timing diagram of an integrated circuit according to an embodiment of this application;
FIG. 6a is still another working timing diagram of an integrated circuit according to an embodiment of this application;
FIG. 6b is still another working timing diagram of an integrated circuit according to an embodiment of this application;
FIG. 7a is still another working timing diagram of an integrated circuit according to an embodiment of this application;
FIG. 7b is still another working timing diagram of an integrated circuit according to an embodiment of this application;
FIG. 8a is still another working timing diagram of an integrated circuit according to an embodiment of this application;
FIG. 8b is still another working timing diagram of an integrated circuit according to an embodiment of this application;
FIG. 9a is still another working timing diagram of an integrated circuit according to an embodiment of this application;
FIG. 9b is still another working timing diagram of an integrated circuit according to an embodiment of this application;
FIG. 10a is still another working timing diagram of an integrated circuit according to an embodiment of this application;
FIG. 10b is still another working timing diagram of an integrated circuit according to an embodiment of this application;
FIG. 11a is still another working timing diagram of an integrated circuit according to an embodiment of this application;
FIG. 11b is still another working timing diagram of an integrated circuit according to an embodiment of this application;
FIG. 12 is a schematic flowchart of controlling work of an integrated circuit according to an embodiment of this application; and
FIG. 13 is another schematic flowchart of controlling work of an integrated circuit according to an embodiment of this application.

Reference numerals:

11: ferroelectric memory unit; 12: comparison circuit; and 13: control circuit.

**DESCRIPTION OF EMBODIMENTS**

To make objectives, technical solutions, and advantages of embodiments of this application clearer, the following clearly and completely describes the technical solutions in embodiments of this application with reference to the accompanying drawings in embodiments of this application. It is clear that the described embodiments are some embodiments of this application rather than all of the embodiments. All other embodiments obtained by a person of ordinary skill in the art based on embodiments of this application without creative efforts shall fall within the protection scope of this application.

The terms "first", "second", and the like in embodiments of the specification, claims, and accompanying drawings of this application are merely used for a purpose of distinguishing description, and cannot be understood as indicating or implying relative importance, nor as indicating or implying a sequence. The term "and/or" is used for describing an association relationship between associated objects, and represents that three relationships may exist. For example, "A and/or B" may represent the following three cases: Only A exists, only B exists, and both A and B exist, where A and B may be singular or plural. A character "/" generally indicates an "or" relationship between the associated objects. "Installation", "connection", "connection to" and the like shall be understood in a broad sense, for example, fixed connection, detachable connection, or integral connection; and can be directly connected, indirectly connected through an intermediate medium, or internally connected between two elements. In addition, the terms "include," "have," and any variant thereof are intended to cover a non-exclusive inclusion, for example, include a series of steps or units. A method, system, product, or device that includes a list of steps or units is not necessarily limited to those expressly listed steps or units, but may include other steps or units not expressly listed or inherent to such a process, method, product, or device. "Up," "down," "left," "right," and the like are used only relative to orientations of components in the accompanying drawings. These directional terms are relative concepts, are used for relative description and clarification, and may change accordingly based on a change of a position in which a component in the accompanying drawings is placed.

Embodiments of this application provide a terminal. The terminal may alternatively be a device having a storage function, like a mobile phone, a computer, a tablet computer, a personal digital assistant (personal digital assistant, PDA for short), an intelligent wearable device, or a smart home device. This is not limited in embodiments of this application. For ease of description, the following uses the mobile phone as an example for description.

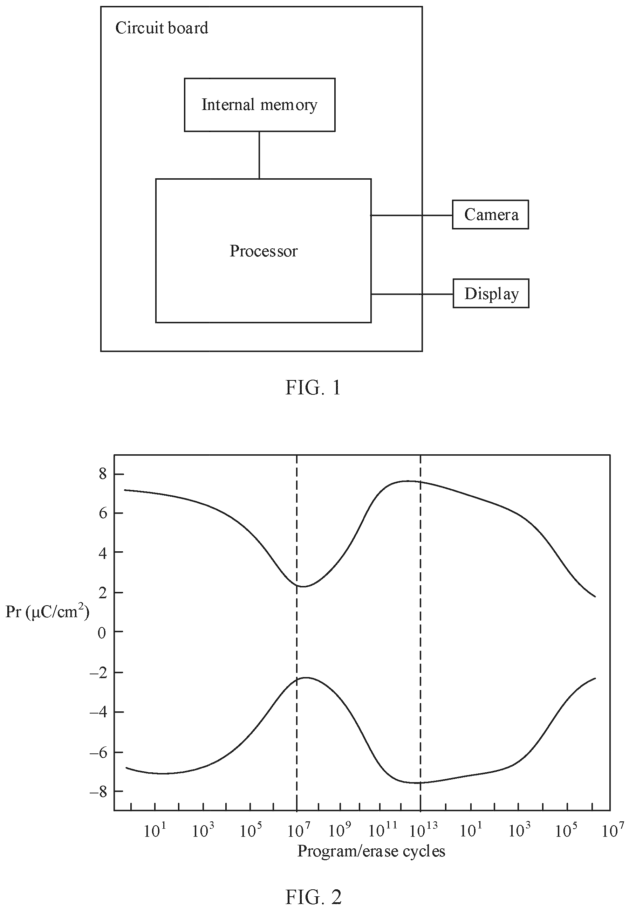

As shown in FIG. 1, the mobile phone may include a display, a camera, a processor, an internal memory, and the like. The internal memory may be configured to store executable program code, and the executable program code includes instructions. The processor runs the instructions stored in the internal memory, to perform various functional applications and data processing of the mobile phone. Certainly, the mobile phone may further include another device having a storage function.

The mobile phone may further include a circuit board and a chip. The processor, the internal memory, and the another device having a storage function may be integrated into one or more chips. The one or more chips integrated with the processor, the internal memory, and the another device having a storage function may be disposed on the circuit board.

In some possible implementations, the internal memory and the another device having a storage function may be ferroelectric memory devices. The ferroelectric memory devices have advantages such as low read/write voltages, low power consumption, small device sizes, high read/write speeds, good cycle performance, radiation resistance, and non-volatility, and can be used to construct next-generation memory chips. The ferroelectric memory device may include at least one ferroelectric memory unit, and each ferroelectric memory unit may include a ferroelectric capacitor. The ferroelectric capacitor may include a first electrode layer, a ferroelectric functional layer, and a second electrode layer that are sequentially stacked.

Compared with that of a conventional ferroelectric material, a thickness of a ferroelectric functional layer of a hafnium-oxide-based ferroelectric memory device may be reduced to 10 nanometers or even sub-10 nanometers, so that high-density integration or even three-dimensional integration can be implemented, and the hafnium-oxide-based ferroelectric memory device has a unique advantage in constructing an ultra-high-density memory chip. In addition, a preparation process of the hafnium-oxide-based ferroelectric memory device is also well compatible with a mature silicon-based semiconductor process. Therefore, the hafnium-oxide-based ferroelectric memory device is expected to become a core unit of a new ferroelectric memory device in the future.

Currently, due to poor endurance of the hafnium-oxide-based ferroelectric memory device, the hafnium-oxide-based ferroelectric memory device is difficult to be widely used in commercial memories. In other words, it is difficult for the hafnium-oxide-based ferroelectric memory device to maintain good ferroelectric performance after a plurality of program/erase cycles. A large quantity of attempts have been made to improve endurance of the hafnium-oxide-based ferroelectric memory device from different perspectives, for example, optimizing of a growth technology of the ferroelectric functional layer, exploration of doping different elements into the ferroelectric functional layer, optimizing of annealing conditions of the first electrode layer, the ferroelectric functional layer, and the second electrode layer, changing of materials of the first electrode layer and the second electrode layer, introducing of a buffer layer on an interface between the first electrode layer and the ferroelectric functional layer and a buffer layer on an interface between the second electrode layer and the ferroelectric functional layer, and the like. Many technical routes have been developed from a material perspective. However, endurance of the hafnium-oxide-based ferroelectric memory device that is currently reported can only reach an order of magnitude being $10^{12}$ program/erase cycles at most, which is far from an order of magnitude being $10^{15}$ program/erase cycles required by the commercial memory. Therefore, how to prolong endurance of the hafnium-oxide-based ferroelectric memory device in a working process is one of problems that urgently need to be resolved currently.

When no external electric field acts on the hafnium-oxide-based ferroelectric memory device, because centers of positive and negative charges in a hafnium-oxide-based ferroelectric functional layer do not overlap, an electric dipole moment is formed, and polarization is generated. A longer distance between the centers of the positive and negative charges in the hafnium-oxide-based ferroelectric functional layer indicates stronger polarization strength. When an electric field is applied to two sides of the hafnium-oxide-based ferroelectric functional layer, polarization of the hafnium-oxide-based ferroelectric functional layer tends to be oriented toward an electric field direction. As electric field strength increases, the centers of the positive and negative charges are further pulled apart, and finally tends to be stable. Polarization strength of the hafnium-oxide-based ferroelectric functional layer also increases, and finally tends to be saturated. When a reverse electric field is applied and electric field strength exceeds a coercive field, an oxygen vacancy in the hafnium-oxide-based ferroelectric functional layer is displaced, and polarization is switched. **In** repeated program/erase cycles of the hafnium-oxide-based ferroelectric memory device, repeated displacement of the oxygen vacancy is accompanied by charge injection and generation, movement, and aggregation of a defect. Consequently, performance of the ferroelectric memory device deteriorates or even the ferroelectric memory device is broken down. Therefore, reducing damage to the hafnium-oxide-based ferroelectric functional layer that occurs in repeated program/erase cycles of the hafnium-oxide-based ferroelectric memory device is a technical route for prolonging endurance performance of the hafnium-oxide-based ferroelectric memory device.

**In** a solution of a related technology, when ferroelectric performance of the ferroelectric memory device deteriorates, a low-frequency high-voltage pulse is usually applied to a first electrode layer or a second electrode layer of the ferroelectric memory device, to restore the ferroelectric performance of the ferroelectric memory device. As shown in FIG. 2, when the ferroelectric functional layer works at a small voltage of $\pm 3$ V, oxygen vacancy accumulation and charge capture are main causes of a failure of the ferroelectric memory device. **In** this case, a low-frequency high-voltage pulse of $\pm 5$ V may be applied to the first electrode layer or the second electrode layer, and the low-frequency high-voltage pulse can be used to effectively drive oxygen vacancy redistribution of the ferroelectric functional layer, and reduce charge capture effect. Therefore, ferroelectric performance of the ferroelectric memory device is improved, and endurance of the ferroelectric memory device is improved.

In the example shown in FIG. 2, if the ferroelectric memory device undergoes repeated program/erase cycles at the pulse voltage of $\pm 3$ V, when a quantity of program/erase cycles reaches an order of magnitude being $10^4$ program/erase cycles, ferroelectric performance of the ferroelectric memory device starts to decrease, and when the quantity of program/erase cycles reaches an order of magnitude being $10^7$ program/erase cycles, remnant polarization of the ferroelectric memory device is close to 0. When the quantity of program/erase cycles reaches the order of magnitude being $10^7$ program/erase cycles, the ferroelectric memory device may be recovered via the voltage of $\pm 5$ V, and when the quantity of program/erase cycles reaches the order of magnitude being $10^4$ program/erase cycles, ferroelectric performance of the ferroelectric memory device is recovered to an initial state.

However, if the ferroelectric memory device continuously undergoes repeated program/erase cycles at a high voltage to improve the remnant polarization, a new defect like an oxygen vacancy is inevitably introduced, and the ferroelectric memory device is damaged. Therefore, it is difficult to recover ferroelectric performance of the ferroelectric memory device after a specific quantity of program/erase cycles. In addition, a solution in which ferroelectric performance is restored by using a high voltage in the related technology can be applied to only ferroelectric performance degradation caused by problems such as oxygen vacancy accumulation and charge capture that are caused because the ferroelectric memory device works at a low voltage.

Based on this, an embodiment of this application provides an integrated circuit. The integrated circuit includes the foregoing ferroelectric memory unit. In this embodiment of this application, a pulse width and/or a voltage during writing or reading may be adjusted, to improve endurance of the ferroelectric memory unit.

The following describes specific work of the integrated circuit in detail with reference to the accompanying drawings.

It is assumed that an initial write state of a ferroelectric memory unit 11 is a first digital signal, and a state in a read phase is a second digital signal, a polarization state of the ferroelectric memory unit 11 may be switched by using a reverse electric field applied to the ferroelectric memory unit 11 in the read phase and the write phase.

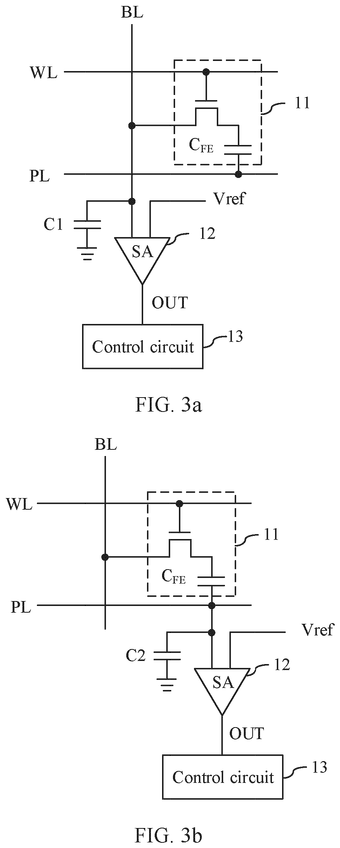

Specifically, as shown in FIG. 3a and FIG. 3b, the integrated circuit includes the ferroelectric memory unit 11, a comparison circuit 12, and a control circuit 13.

The ferroelectric memory unit 11 is configured to: write a first digital signal in a write phase, write a second digital signal in a read phase, switch a polarization state of the ferroelectric memory unit 11 in the read phase, to obtain a target voltage, and input the target voltage to the comparison circuit, where the first digital signal is different from the second digital signal.

The comparison circuit 12 is configured to: compare the target voltage with a reference voltage, and if the target voltage is greater than the reference voltage, input a first comparison result to the control circuit 13.

The control circuit 13 is configured to: receive the first comparison result, control the ferroelectric memory unit 11 to repeat the write phase and the read phase, gradually decrease a read pulse width and/or a read voltage of the read phase until a second comparison result that is input by the comparison circuit 12 and that indicates that the target voltage is less than or equal to the reference voltage is received, and select a read pulse width and/or a read voltage previous to reception of the second comparison result for the first time as a read pulse width and/or a read voltage of the read phase.

In some possible implementations, the ferroelectric memory unit 11 may include a transistor and a ferroelectric capacitor CFE that are electrically connected. A quantity of transistors and a quantity of ferroelectric capacitors CFE are not limited in embodiments of this application. The ferroelectric memory unit 11 may include one transistor and one ferroelectric capacitor CFE, or may include a plurality of transistors and a plurality of ferroelectric capacitors CFE. The transistor may include a P-type transistor and/or an N-type transistor.

In some possible implementations, the integrated circuit may further include a word line (word line, WL), a bit line (bit Line, BL), and a plate line (plate line, PL). Potentials of the word line WL, the bit line BL, and the plate line PL may be controlled to write the first digital signal into the ferroelectric memory unit 11 in the write phase and write the second digital signal into the ferroelectric memory unit 11 in the read phase. The word line WL may be electrically connected to a gate of the transistor, to control the transistor to be conducted or disconnected. The bit line BL is electrically connected to a first electrode of the transistor, and is electrically connected to a first electrode layer of the ferroelectric capacitor CFE through the transistor. The plate line PL is electrically connected to a second electrode layer of the ferroelectric capacitor CFE, and is electrically connected to a second electrode of the transistor through the ferroelectric capacitor CFE. The first electrode of the transistor may be a source, and the second electrode of the transistor may be a drain; or the first electrode of the transistor is a drain, and the second electrode of the transistor is a source.

It should be noted that, a person skilled in the art should know that if the transistor is an N-type transistor, when a potential on the word line WL is at a high level, the transistor is conducted; or if the transistor is a P-type transistor, when a potential on the word line WL is at a low level, the transistor is conducted. For ease of description, the following uses an example in which the transistor is an N-type transistor for description.

In some possible implementations, in this embodiment of this application, potentials on the bit line BL and the plate line PL may be controlled to control a signal written into the ferroelectric memory unit to be 0 or 1. For example, when the transistor is conducted, if the potential on the bit line BL is at a high level, and the potential on the plate line PL is at a low level, the signal written into the ferroelectric capacitor CFE is 1; and if the potential on the bit line BL is at a low level, and the potential on the plate line PL is at a high level, the signal written into the ferroelectric capacitor CFE is 0. For another example, when the transistor is conducted, if the potential on the bit line BL is at a high level, and the potential on the plate line PL is at a low level, the signal written into the ferroelectric capacitor CFE is 0; and if the potential on the bit line BL is at a low level, and the potential on the plate line PL is at a high level, the signal written into the ferroelectric capacitor CFE is 1. For ease of description, in the following, when the potential on the bit line BL is at a high level, and the potential on the plate line PL is at a low level, the signal written into the ferroelectric capacitor CFE is 1; and when the potential on the bit line BL is at a low level, and the potential on the plate line PL is at a high level, the signal written into the ferroelectric capacitor CFE is 0.

In some possible implementations, in the integrated circuit, a written digital signal and a read digital signal each may include 0 and 1. In this embodiment of this application, a digital signal used to be written (the first digital signal) may be 0 and 1, but a digital signal used to be read (the second digital signal) can only be 0 or 1 in a same embodiment. To be specific, the first digital signal is 1, and the second digital signal is 0; and the first digital signal is 0, and the second digital signal is 0. Alternatively, the first digital signal is 0, and the second digital signal is 1; and the first digital signal is 1, and the second digital signal is 1.

In addition, the first comparison result and the second comparison result that are output by the comparison circuit 12 may also be output in form of a digital signal 1 or a digital signal 0. For example, if the target voltage is greater than the reference voltage Vref, the first comparison result output by the comparison circuit 12 is 1; or if the target voltage is less than or equal to the reference voltage Vref, the second comparison result output by the comparison circuit 12 is 0. For another example, if the target voltage is greater than the reference voltage Vref, the first comparison result output by the comparison circuit 12 is 0; or if the target voltage is less than or equal to the reference voltage Vref, the second comparison result output by the comparison circuit 12 is 1. For ease of description, the following uses an example in which the first comparison result is 1 and the second comparison result is 0 for description.

As mentioned above, ferroelectric performance of the ferroelectric memory unit 11 gradually decreases after repeated program/erase cycles at a low voltage, which may specifically represent that reading is insufficient in the read phase, and writing is insufficient in the write phase. In addition, the ferroelectric performance of the ferroelectric memory unit 11 may be also low in a scenario other than a scenario in which the ferroelectric memory unit 11 undergoes repeated program/erase cycles at a low voltage. For example, in a test phase before mass production of the integrated circuit, because a voltage applied to the first electrode layer or the second electrode layer of the ferroelectric capacitor CFE is small, reading in the read phase is insufficient, or writing in the write phase is insufficient.

The following uses an example of detecting whether reading is sufficient in the read phase to describe a working principle of the integrated circuit provided in this embodiment of this application.

In a first case, refer to the circuit structure of the integrated circuit shown in FIG. 3a. Based on the foregoing circuit connection relationship, the bit line BL is further electrically connected to an input end of the comparison circuit 12. The first digital signal may be 1, and the second digital signal may be 0.

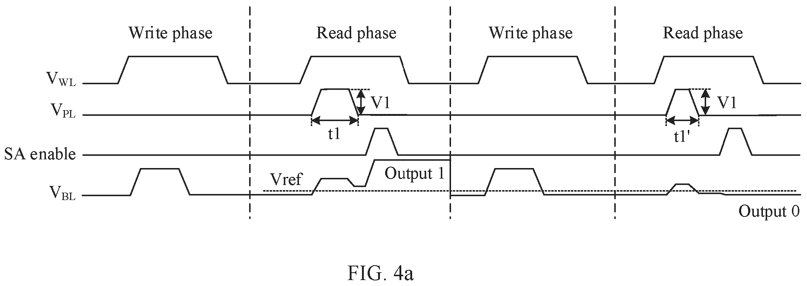

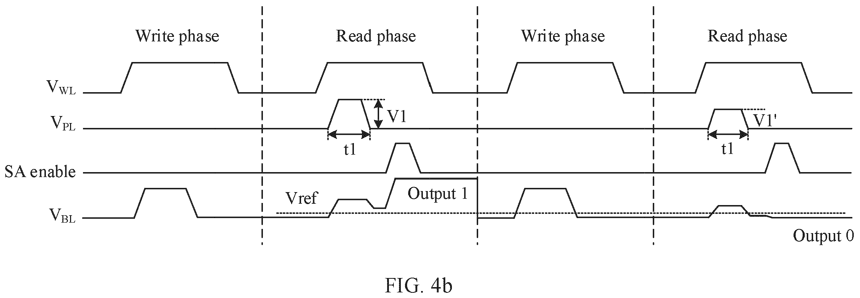

As shown in FIG. 4a and FIG. 4b, in the write phase, the potential on the word line WL is at a high level, and the transistor is conducted. The potential on the bit line BL is at a high level, and the potential on the plate line PL is at a low level. A charge on the bit line BL is written into the ferroelectric capacitor CFE through the transistor, to be specific, the first digital signal 1 is written into the ferroelectric capacitor CFE.

Still refer to FIG. 4a and FIG. 4b. In the read phase, the potential on the word line WL is at a high level, and the transistor is conducted. The potential on the plate line PL is at a high level, and the potential on the bit line BL is at a low level. A charge on the plate line PL is written into the ferroelectric capacitor CFE through the transistor, to be specific, the second digital signal 0 is written into the ferroelectric capacitor CFE, to read the charge in the ferroelectric capacitor CFE to the bit line BL. As shown in FIG. 4a and FIG. 4b, after a voltage on the plate line PL is removed, a voltage on the bit line BL increases.

Because a direction of an electric field applied to the ferroelectric capacitor CFE in the write phase is opposite to a direction of an electric field applied to the ferroelectric capacitor CFE in the read phase, the polarization state of the ferroelectric capacitor CFE is switched, and a total quantity of read charges $Q=2PrAMFM$, where Pr represents remnant polarization of the ferroelectric capacitor CFE, and AMFM represents an area of an overlapping region of the first electrode layer, the second electrode layer, and the ferroelectric functional layer.

It can be learned according to the formula $Q=2PrAMFM$ that the remnant polarization Pr of the ferroelectric capacitor CFE is related to a total quantity Q of charges read in the read phase. A larger total quantity Q of read charges indicates larger remnant polarization Pr of the ferroelectric capacitor CFE. On the contrary, a smaller total quantity Q of read charges indicates smaller remnant polarization Pr of the ferroelectric capacitor CFE.

In addition, it should be noted that, because the bit line BL is electrically connected to the ferroelectric capacitor CFE through the transistor, in the read phase, the potential on the bit line BL may be temporarily pulled up by the potential on the plate line PL. That is, as shown in FIG. 4a and FIG. 4b, in a time period in which the plate line PL is at a high level, the potential on the bit line BL increases, and the voltage on the bit line BL may be less than the voltage on the plate line PL.

Still refer to FIG. 4a and FIG. 4b. In the read phase, the charge read from the ferroelectric capacitor CFE may be input to the input end of the comparison circuit 12 through the bit line BL.

In some possible implementations, as shown in FIG. 3a, the integrated circuit may further include a first capacitor C1, and the first capacitor C1 is electrically connected to the input end of the comparison circuit 12 and the bit line BL. The first capacitor C1 is configured to receive and store a charge released when polarization of the ferroelectric capacitor CFE is switched. When the comparison circuit 12 is enabled, the first capacitor C1 inputs the stored charge to the comparison circuit 12 in a voltage form. In other words, the first capacitor C1 inputs the target voltage to the comparison circuit 12. The target voltage may be a voltage change value $\Delta V_{BL}$ of the bit line BL after removing of the voltage on the plate line PL.

According to a formula among a capacitance, a voltage, and a charge, the voltage change value

$$\Delta V_{BL} = \frac{2 Pr A_{MFM}}{C_1}$$

of the bit line BL after removing of the voltage on the plate line PL can be obtained, where C1 represents a capacitance value of the first capacitor C1, and the voltage change value $\Delta V_{BL}$ of the bit line BL is a storage window of the ferroelectric capacitor CFE, and represents a difference between a voltage on the bit line BL after removing of the voltage on the plate line PL in the read phase and an initial voltage on the bit line BL in the read phase.

After being enabled, the comparison circuit 12 may compare the received target voltage $\Delta V_{BL}$ with the reference voltage Vref. If the target voltage $\Delta V_{BL}$ is greater than the reference voltage Vref, the comparison circuit 12 outputs the first comparison result 1, to indicate that there are enough charges participating in ferroelectric polarization state switching, and that the remnant polarization Pr is enough to write the second digital signal 0 in the read phase. If the target voltage $\Delta V_{BL}$ is less than or equal to the reference voltage Vref, the comparison circuit 12 outputs the second comparison result 0, to indicate that there are not enough charges participating in ferroelectric polarization state switching, and that the remnant polarization Pr is not enough to write the second digital signal 0 in the read phase.

However, as mentioned above, when the remnant polarization Pr is enough to write the second digital signal 0 in the read phase, if the remnant polarization Pr is excessively large, a defect like a new oxygen vacancy is inevitably introduced, and the ferroelectric capacitor CFE is damaged. Therefore, when the remnant polarization Pr is enough to write the second digital signal 0 in the read phase, the remnant polarization Pr of the ferroelectric capacitor CFE may be reduced as much as possible, to prolong endurance of the ferroelectric capacitor CFE.

It can be learned according to the formula Q=2PrAMFM that the remnant polarization Pr is positively correlated with a total quantity Q of charges read in the read phase, and the read voltage and the read pulse width of the read phase determine the total quantity Q of charges read in the read phase. Therefore, in this embodiment of this application, endurance of the ferroelectric capacitor CFE may be prolonged by adjusting the read voltage and the read pulse width of the read phase. It should be noted herein that, in this embodiment, the read voltage and the read pulse width of the read phase are a voltage and a pulse width that are applied to the plate line PL in the read phase.

Specifically, as shown in FIG. 4a and FIG. 4b, the first digital signal 1 may be first written, and then a read operation is performed based on the read voltage V1 and the read pulse width t1, to write the second digital signal 0. After being enabled, the comparison circuit 12 compares the received target voltage $\Delta V_{BL}$ with the reference voltage Vref, and then inputs the first comparison result 1 to the control circuit 13. To avoid damage to the ferroelectric capacitor CFE due to excessively high remnant polarization Pr resulting from the current read voltage V1 and the current read pulse width t1, the first digital signal 1 continues to be written, and the control circuit 13 controls the read voltage V1 to decrease to a read voltage V1' and/or the control circuit 13 controls the read pulse width t1 to decrease to a read pulse width t1', to perform a read operation based on the read voltage V1' and the read pulse width t1', or the read voltage V1' and the read pulse width t1, or the read voltage V1 and the read pulse width t1', and write the second digital signal 0. If the comparison circuit 12 inputs the second comparison result 0 to the control circuit 13, a previous read voltage V1 and a previous read pulse width t1 are selected as the read voltage and the read pulse width of the read phase; and if the comparison circuit 12 still inputs the first comparison result 1 to the control circuit 13, the foregoing write and read operations are still repeated, and the control circuit 13 controls the read voltage V1' and/or the read pulse width t1' to gradually decrease until the comparison circuit 12 inputs the second comparison result 0 to the control circuit 13, and selects, as a read voltage and a read pulse width of the read phase, a read voltage V1' and a read pulse width t1' (or a read voltage V1' and a read pulse width t1, or a read voltage V1 and a read pulse width t1') previous to outputting the second comparison result 0 by the comparison circuit 12.

Because the control circuit 13 controls the read voltage V1' and/or the read pulse width t1' to gradually decrease, the next read voltage V1' and/or the next read pulse width t1' are/is always less than the previous read voltage V1' and/or the previous read pulse width t1' (or the read voltage V1 and/or the read pulse width t1). Therefore, the remnant polarization Pr of the ferroelectric capacitor CFE gradually decreases. In addition, because the comparison circuit 12 outputs the second comparison result 0 after outputting the first comparison result 1, it indicates that fewer charges and lower remnant polarization Pr participate in ferroelectric polarization state switching, and that the remnant polarization Pr is not enough to write 0 in the read phase. Therefore, the read voltage V1' and the read pulse width t1' (or the read voltage V1' and the read pulse width t1, or the read voltage V1 and the read pulse width t1') previous to outputting the second comparison result 0 by the comparison circuit 12 are selected as the read voltage and the read pulse width of the read phase.

In this way, the read voltage and the read pulse width of the read phase can ensure that there are enough charges participating in ferroelectric polarization state switching, and that the remnant polarization Pr is enough to write 0 in the read phase. This can further avoid excessively large remnant polarization Pr caused by an excessively high read voltage and/or an excessively large read pulse width. Therefore, the ferroelectric capacitor CFE is not damaged, and endurance of the ferroelectric capacitor CFE is not affected.

It should be noted herein that a step for decreasing the read voltage and the read pulse width is not limited in this embodiment of this application. When the read voltage and the read pulse width are decreased a plurality of times, the read voltage may be decreased by using a same step, and the read pulse width may be decreased by using a same step; or the read voltage may be decreased by using different steps, and the read pulse width may be decreased by using different steps.

For example, the read voltage is decreased by using a same step, and the read pulse width is decreased by using a same step. A manner of decreasing the read voltage may be V'=V - $\Delta$V, that is, the current read voltage V decreasing by $\Delta$V is equal to the next read voltage V'. A manner of decreasing the read pulse width may be t'=t - $\Delta$t, that is, the current read pulse width t decreasing by $\Delta$t is equal to the next read pulse width t'. Both $\Delta$V and $\Delta$t are positive numbers.

For another example, the read voltage is decreased by using different steps, and the read pulse width is decreased by using different steps. A manner of decreasing the read voltage may be V'=V * (1 - $\Delta$V), that is, the current read voltage V decreasing by V*$\Delta$V is equal to the next read voltage V'. A manner of decreasing the read pulse width may be t'=t = (1 - $\Delta$t), that is, the current read pulse width t decreasing by t*$\Delta$t is equal to the next read pulse width t'. Both $\Delta$V and $\Delta$t are positive numbers. In some possible implementations, $\Delta$V may be 1%, 5%, 10%, or the like of the current read voltage V, and $\Delta$t may be 1%, 5%, 10%, or the like of the current pulse width t.

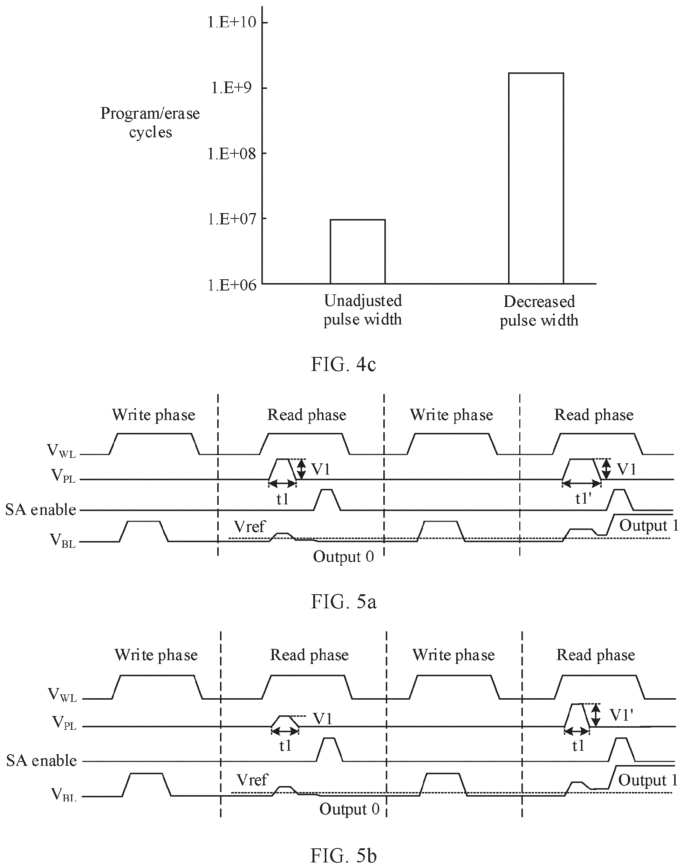

FIG. 4c is a diagram of comparison obtained through an experiment in which endurance of a ferroelectric capacitor CFE is prolonged by decreasing a read pulse width. The read pulse width is decreased in the manner in this embodiment of this application, so that a quantity of program/erase cycles of the ferroelectric capacitor CFE can be extended from 106 to 109. This effectively prolongs endurance of the ferroelectric capacitor CFE.

The foregoing embodiment illustrates a case in which reading is sufficient and the remnant polarization Pr is excessively large upon detection of whether reading is sufficient in the read phase. In some other embodiments, upon detection of whether reading is sufficient in the read phase, the comparison circuit 12 may further output the second comparison result 0, to indicate that there are not enough charges participating in ferroelectric polarization state switching, and that the remnant polarization Pr is not enough to write the second digital signal 0 in the read phase.

In this case, this application may further disclose another embodiment. In this embodiment, the read voltage and the read pulse width of the read phase may also be adjusted. The remnant polarization of the ferroelectric capacitor CFE is improved, to ensure that the ferroelectric capacitor CFE can work normally. In addition, the ferroelectric capacitor CFE is not damaged due to excessively high remnant polarization of the ferroelectric capacitor CFE.

Specifically, as shown in FIG. 5a and FIG. 5b, the first digital signal 1 may be first written, and then a read operation is performed based on the read voltage V1 and the read pulse width t1, to write the second digital signal 0. After being enabled, the comparison circuit 12 compares the received target voltage $\Delta V_{BL}$ with the reference voltage Vref, and then inputs the second comparison result 0 to the control circuit 13. Then, the ferroelectric capacitor CFE may work normally, and the first digital signal 1 continues to be written. The control circuit 13 controls the read voltage V1 to increase to the read voltage V1', and/or the control circuit 13 controls the read pulse width t1 to increase to the read pulse width t1', to perform a read operation based on the read voltage V1' and the read pulse width t1', or the read voltage V1' and the read pulse width t1, or the read voltage V1 and the read pulse width t1', and write the second digital signal 0. If the comparison circuit 12 inputs the first comparison result 1 to the control circuit 13, the current read voltage and the current read pulse width are selected as the read voltage and the read pulse width of the read phase; and if the comparison circuit 12 still inputs the second comparison result 0 to the control circuit 13, the foregoing write and read operations are still repeated, and the control circuit 13 controls the read voltage V1' and/or the read pulse width t1' to gradually increase until the comparison circuit 12 inputs the first comparison result 1 to the control circuit 13, and selects, as a read voltage and a read pulse width of the read phase, a read voltage and a read pulse width upon outputting the first comparison result 1 for the first time by the comparison circuit 12.

Because the control circuit 13 controls the read voltage V1' and/or the read pulse width t1' to gradually increase, the next read voltage V1' and/or the next read pulse width t1' are/is always greater than the previous read voltage V1' and/or the previous read pulse width t1' (or the read voltage V1 and the read pulse width t1). Therefore, the remnant polarization Pr of the ferroelectric capacitor CFE gradually increases. In addition, because the comparison circuit 12 outputs the first comparison result 1 after outputting the second comparison result 0, it indicates that more charges and higher remnant polarization Pr participate in ferroelectric polarization state switching, and that the remnant polarization Pr is enough to write 0 in the read phase. Therefore, the read voltage and the read pulse width upon outputting the first comparison result 1 for the first time may be selected as the read voltage and the read pulse width of the read phase.

This can ensure that the ferroelectric capacitor CFE meets a storage function, and can also ensure that there are enough charges participating in ferroelectric polarization state switching, and that the remnant polarization Pr is enough to write 0 in the read phase, to avoid excessively large remnant polarization Pr caused by an excessively high read voltage and/or an excessively large read pulse width. Therefore, the ferroelectric capacitor CFE is not damaged, and endurance of the ferroelectric capacitor CFE is not affected.

It should be noted herein that a step for increasing the read voltage and the read pulse width is not limited in this embodiment of this application. When the read voltage and the read pulse width are increased a plurality of times, the read voltage may be increased by using a same step, and the read pulse width may be increased by using a same step; or the read voltage may be increased by using different steps, and the read pulse width may be increased by using different steps.

For example, the read voltage is increased by using a same step, and the read pulse width is increased by using a same step. A manner of increasing the read voltage may be V'=V + ΔV, that is, the current read voltage V increasing by ΔV is equal to the next read voltage V'. A manner of increasing the read pulse width may be t'=t + Δt, that is, the current read pulse width t increasing by Δt is equal to the next read pulse width t'. Both ΔV and Δt are positive numbers.

For another example, the read voltage is increased by using different steps, and the read pulse width is increased by using different steps. A manner of increasing the read voltage may be V'=V * (1 + ΔV), that is, the current read voltage V increasing by V*ΔV is equal to the next read voltage V'. A manner of increasing the read pulse width may be t'=t * (1 + Δt), that is, the current read pulse width t increasing by t*Δt is equal to the next read pulse width t'. Both ΔV and Δt are positive numbers. In some possible implementations, ΔV may be 1%, 5%, 10%, or the like of the current read voltage V, and Δt may be 1%, 5%, 10%, or the like of the current pulse width t. After the adjusted read voltage increases to 4 V or increases to 1.5 times the initial voltage V, the control circuit 13 may no longer control the read voltage to continue to increase. After the adjusted read pulse width increases to 2 μs, the control circuit 13 may no longer control the read pulse width to continue to increase.

In addition, it should be noted that the foregoing two embodiments respectively describe a solution in which the comparison circuit 12 outputs the first comparison result 1 and the control circuit 13 controls the read voltage and/or the read pulse width on the plate line PL to decrease, and a solution in which the comparison circuit outputs the second comparison result 0 and the control circuit 13 controls the read voltage and/or the read pulse width on the plate line PL to increase. In some other possible implementations, the two solutions may alternatively be combined to determine a more appropriate read voltage and/or the read pulse width, so that the remnant polarization of the ferroelectric capacitor CFE is enough to enable the ferroelectric capacitor CFE to work normally. In addition, the ferroelectric capacitor CFE is not damaged due to excessively high remnant polarization of the ferroelectric capacitor CFE.

Specifically, the manner in the foregoing embodiment is still used to write the first digital signal 1 in the write phase, and write the second digital signal 0 in the read phase. If the comparison circuit 12 inputs the first comparison result 1 to the control circuit 13, the read voltage V1 and/or the read pulse width t1 may be gradually decreased until the comparison circuit 12 inputs the second comparison result 0 to the control circuit 13. In this way, the read voltage V1 and/or the read pulse width t1 upon outputting the second comparison result 0 by the comparison circuit 12 is compared with the previous read voltage V1 and/or the previous read pulse width t1, and a step is a first step. Then, the read voltage V1 and/or the read pulse width t1 may be gradually increased by using a second step until the comparison circuit 12 inputs the first comparison result 1 to the control circuit 13. The control circuit 13 selects, as a read pulse width and/or a read voltage in the read phase, a read voltage V1 and/or a read pulse width t1 upon reception of the first comparison result 1 this time. The first step is greater than the second step. That is, the first step used to decrease the read voltage V1 is greater than the second step used to increase the read voltage V1, and the first step used to decrease the read pulse width t1 is greater than the second step used to increase the read pulse width t1.

Alternatively, the first digital signal 1 is still written in the write phase, and the second digital signal 0 is still written in the read phase in the manner in the foregoing embodiment. If the comparison circuit 12 inputs the second comparison result 0 to the control circuit 13, the read voltage V1 and/or the read pulse width t1 may be gradually increased until the comparison circuit 12 inputs the first comparison result 1 to the control circuit 13. In this way, the read voltage V1 and/or the read pulse width t1 upon outputting the first comparison result 1 by the comparison circuit 12 is compared with the previous read voltage V1 and/or the previous read pulse width t1, and a step is a first step. Then, the read voltage V1 and/or the read pulse width t1 may be gradually decreased by using a second step until the comparison circuit 12 inputs the second comparison result 0 to the control circuit 13. The control circuit 13 selects, as a read pulse width and/or a read voltage of the read phase, a read voltage V1 and/or a read pulse width t1 previous to reception of the second comparison result 0 this time. The first step is greater than the second step. That is, the first step used to increase the read voltage V1 is greater than the second step used to decrease the read voltage V1, and the first step used to increase the read pulse width t1 is greater than the second step used to decrease the read pulse width t1.

In a second case, refer to the circuit structure of the integrated circuit shown in FIG. 3b. The plate line PL is further electrically connected to the input end of the comparison circuit 12. The first digital signal may be 0, and the second digital signal may be 1.

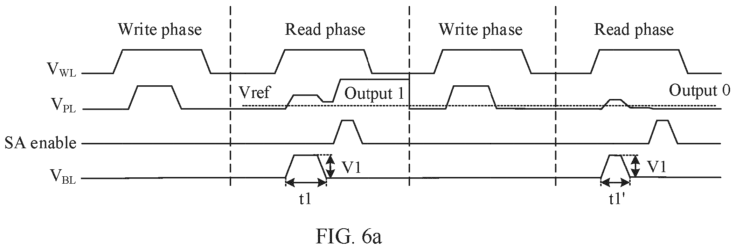

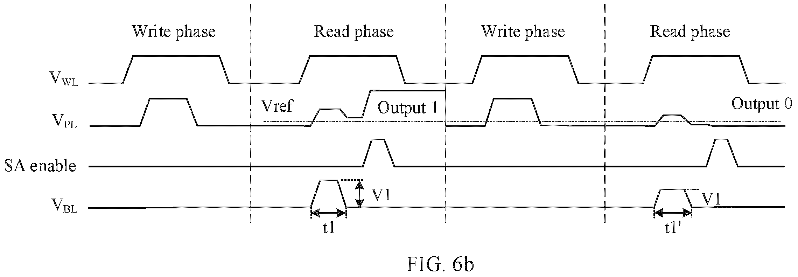

As shown in FIG. 6a and FIG. 6b, in the write phase, the potential on the word line WL is at a high level, and the transistor is conducted. The potential on the bit line BL is at a low level, and the potential on the plate line PL is at a high level. A charge on the plate line PL is written into the ferroelectric capacitor CFE through the transistor, to be specific, the first digital signal 0 is written into the ferroelectric capacitor CFE.

Still refer to FIG. 6a and FIG. 6b. In the read phase, the potential on the word line WL is at a high level, and the transistor is conducted. The potential on the plate line PL is at a low level, the potential on the bit line BL is at a high level. A charge on the bit line BL is written into the ferroelectric capacitor CFE through the transistor, to be specific, the second digital signal 1 is written into the ferroelectric capacitor CFE, to read the charge in the ferroelectric capacitor CFE to the plate line PL. As shown in FIG. 6a and FIG. 6b, after a voltage on the bit line BL is removed, a voltage on the plate line PL increases.

Because a direction of an electric field applied to the ferroelectric capacitor CFE in the write phase is opposite to a direction of an electric field applied to the ferroelectric capacitor CFE in the read phase, the polarization state of the ferroelectric capacitor CFE is switched, and a total quantity of read charges Q=2PrAMFM.

It can be learned according to the formula Q=2PrAMFM that the remnant polarization Pr of the ferroelectric capacitor CFE is related to a total quantity Q of charges read in the read phase. A larger total quantity Q of read charges indicates larger remnant polarization Pr of the ferroelectric capacitor CFE. On the contrary, a smaller total quantity Q of read charges indicates smaller remnant polarization Pr of the ferroelectric capacitor CFE.

In addition, it should be noted that, because the plate line PL is electrically connected to the ferroelectric capacitor CFE through the transistor, in the read phase, the potential on the plate line PL may be temporarily pulled up by the potential on the bit line BL. That is, as shown in FIG. 6a and FIG. 6b, in a time period in which the bit line BL is at a high level, the potential on the plate line PL increases, and the voltage on the plate line PL may be less than the voltage on the bit line BL.

Still refer to FIG. 6a and FIG. 6b. In the read phase, the charge read from the ferroelectric capacitor CFE may be input to the input end of the comparison circuit 12 through the plate line PL.

In some possible implementations, as shown in FIG. 3b, the integrated circuit may further include a second capacitor C2, and the second capacitor C2 is electrically connected to the input end of the comparison circuit 12 and the plate line PL. The second capacitor C2 is configured to receive and store a charge released when polarization of the ferroelectric capacitor CFE is switched. When the comparison circuit 12 is enabled, the second capacitor C2 inputs the stored charge to the comparison circuit 12 in a voltage form. In other words, the second capacitor C2 inputs a target voltage to the comparison circuit 12. The target voltage may be a voltage change value $\Delta V_{PL}$ of the plate line PL after removing of the voltage on the bit line BL. According to a formula among a capacitance, a voltage, and a charge,

$$\Delta V_{PL} = \frac{2PrA_{MFM}}{C_2}$$ of the plate line PL after removing of the voltage on the bit line BL can be obtained, where C2 represents a capacitance value of the second capacitor C2, and the voltage change value ΔVPL of the plate line PL is a storage window of the ferroelectric capacitor CFE, and represents a difference between a voltage on the plate line PL after removing of the voltage on the bit line BL in the read phase and an initial voltage on the plate line PL in the read phase.

After being enabled, the comparison circuit 12 may compare the received target voltage ΔVPL with the reference voltage Vref. If the target voltage ΔVPL is greater than the reference voltage Vref, the comparison circuit 12 outputs the first comparison result 1, to indicate that there are enough charges participating in ferroelectric polarization state switching, and that the remnant polarization Pr is enough to write 0 in the read phase. If the target voltage ΔVPL is less than or equal to the reference voltage Vref, the comparison circuit 12 outputs the second comparison result 0, to indicate that there are not enough charges participating in ferroelectric polarization state switching, and that the remnant polarization Pr is not enough to write 0 in the read phase.

However, as mentioned above, when the remnant polarization Pr is enough to write 0 in the read phase, if the remnant polarization Pr is excessively large, a defect like a new oxygen vacancy is inevitably introduced, and the ferroelectric capacitor CFE is damaged. Therefore, when the remnant polarization Pr is enough to write 0 in the read phase, the remnant polarization Pr of the ferroelectric capacitor CFE may be reduced as much as possible, to prolong endurance of the ferroelectric capacitor CFE.

It can be learned according to the formula Q=2PrAMFM that the remnant polarization Pr is positively correlated with a total quantity Q of charges read in the read phase, and the read voltage and the read pulse width of the read phase determine the total quantity Q of charges read in the read phase. Therefore, in this embodiment of this application, endurance of the ferroelectric capacitor CFE may be prolonged by adjusting the read voltage and the read pulse width of the read phase. It should be noted herein that, in this embodiment, the read voltage and the read pulse width of the read phase are a voltage and a pulse width that are applied to the bit line BL in the read phase.

Specifically, as shown in FIG. 6a and FIG. 6b, the first digital signal 0 may be first written, and then a read operation is performed based on the read voltage V1 and the read pulse width t1, to write the second digital signal 1. The comparison circuit 12 compares the received target voltage ΔVPL with the reference voltage Vref, and then inputs the first comparison result 1 to the control circuit 13. To avoid damage to the ferroelectric capacitor CFE due to excessively high remnant polarization Pr resulting from the current read voltage V1 and the current read pulse width t1, the first digital signal 0 continues to be written, and the control circuit 13 controls the read voltage V1 to decrease to a read voltage V1' and/or the control circuit 13 controls the read pulse width t1 to decrease to a read pulse width t1', to perform a read operation based on the read voltage V1' and the read pulse width t1', or the read voltage V1' and the read pulse width t1, or the read voltage V1 and the read pulse width t1', and write the second digital signal 1. If the comparison circuit 12 inputs the second comparison result 0 to the control circuit 13, the previous read voltage V1 and the previous read pulse width t1 are selected as the read voltage and the read pulse width of the read phase; and if the comparison circuit 12 still inputs the first comparison result 1 to the control circuit, the foregoing write and read operations are still repeated, and the control circuit 13 controls the read voltage V1' and/or the read pulse width t1' to gradually decrease until the comparison circuit 12 inputs the second comparison result 0 to the control circuit 13, and selects, as a read voltage and a read pulse width of the read phase, a read voltage V1' and a read pulse width t1' (or a read voltage V1' and a read pulse width t1, or a read voltage V1 and a read pulse width t1') previous to outputting the second comparison result 0 by the comparison circuit 12.

Because the control circuit 13 controls the read voltage V1' and/or the read pulse width t1' to gradually decrease, the next read voltage V1' and/or the next read pulse width t1' are/is always less than the previous read voltage V1' and/or the previous read pulse width t1' (or the read voltage V1 and/or the read pulse width t1). Therefore, the remnant polarization Pr of the ferroelectric capacitor CFE gradually decreases. In addition, because the comparison circuit 12 outputs the second comparison result 0 after outputting the first comparison result 1, it indicates that fewer charges and lower remnant polarization Pr participate in ferroelectric polarization state switching, and that the remnant polarization Pr is not enough to write 0 in the read phase. Therefore, the read voltage V1' and the read pulse width t1' (or the read voltage V1' and the read pulse width t1, or the read voltage V1 and the read pulse width t1') previous to outputting the second comparison result 0 by the comparison circuit 12 are selected as the read voltage and the read pulse width of the read phase.

In this way, the read voltage and the read pulse width of the read phase can ensure that there are enough charges participating in ferroelectric polarization state switching, and that the remnant polarization Pr is enough to write 0 in the read phase. This can further avoid excessively large remnant polarization Pr caused by an excessively high read voltage and/or an excessively large read pulse width. Therefore, the ferroelectric capacitor CFE is not damaged, and endurance of the ferroelectric capacitor CFE is not affected.

It should be noted herein that a step for decreasing the read voltage and the read pulse width is not limited in this embodiment of this application. When the read voltage and the read pulse width are decreased a plurality of times, the read voltage may be decreased by using a same step, and the read pulse width may be decreased by using a same step; or the read voltage may be decreased by using different steps, and the read pulse width may be decreased by using different steps. A specific example description may be the same as the example description of decreasing the read voltage and the read pulse width in the foregoing embodiment, and details are not described herein again.

The foregoing embodiment illustrates a case in which reading is sufficient and the remnant polarization Pr is excessively large upon detection of whether reading is sufficient in the read phase. In some other embodiments, upon detection of whether reading is sufficient in the read phase, the comparison circuit 12 may further output the second comparison result 0, to indicate that there are not enough charges participating in ferroelectric polarization state switching, and that the remnant polarization Pr is not enough to write 0 in the read phase.

In this case, this application may further disclose another embodiment. In this embodiment, the read voltage and the read pulse width of the read phase may also be adjusted. The remnant polarization of the ferroelectric capacitor CFE is improved, to ensure that the ferroelectric capacitor CFE can work normally. In addition, the ferroelectric capacitor CFE is not damaged due to excessively high remnant polarization of the ferroelectric capacitor CFE.

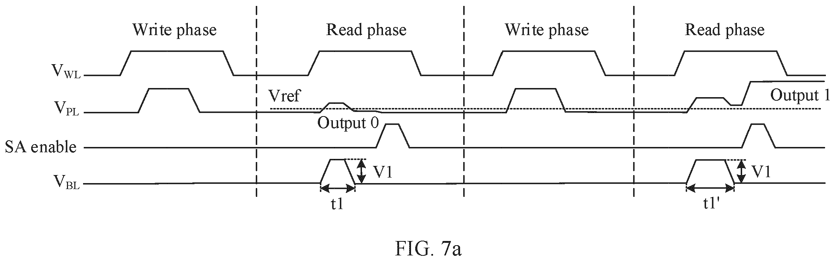

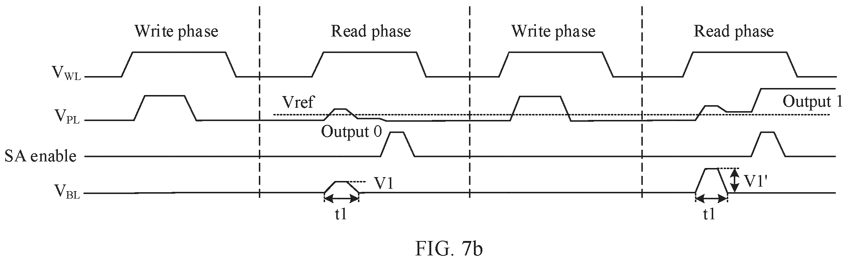

Specifically, as shown in FIG. 7a and FIG. 7b, the first digital signal 0 may be first written, and then a read operation is performed based on the read voltage V1 and the read pulse width t1, to write the second digital signal 1. The comparison circuit 12 compares the received target voltage ∆VPL with the reference voltage Vref, and then inputs the second comparison result 0 to the control circuit 13. Then, to ensure that the ferroelectric capacitor CFE can work normally, the first digital signal 0 continues to be written. The control circuit 13 controls the read voltage V1 to increase to the read voltage V1', and/or the control circuit 13 controls the read pulse width t1 to increase to the read pulse width t1', to perform a read operation based on the read voltage V1' and the read pulse width t1', or the read voltage V1' and the read pulse width t1, or the read voltage V1 and the read pulse width t1', and write the second digital signal 1. If the comparison circuit 12 inputs the first comparison result 1 to the control circuit 13, the current read voltage and the current read pulse width are selected as the read voltage and the read pulse width of the read phase; and if the comparison circuit 12 still inputs the second comparison result 0 to the control circuit 13, the foregoing write and read operations are still repeated, and the control circuit 13 controls the read voltage V1' and/or the read pulse width t1' to gradually increase until the comparison circuit 12 inputs the first comparison result 1 to the control circuit 13, and selects, as a read voltage and a read pulse width of the read phase, a read voltage and a read pulse width upon outputting the first comparison result 1 for the first time by the comparison circuit 12.

Because the control circuit 13 controls the read voltage V1' and/or the read pulse width t1' to gradually increase, the next read voltage V1' and/or the next read pulse width t1' are/is always greater than the previous read voltage V1' and/or the previous read pulse width t1' (or the read voltage V1 and the read pulse width t1). Therefore, the remnant polarization Pr of the ferroelectric capacitor CFE gradually increases. In addition, because the comparison circuit 12 outputs the first comparison result 1 after outputting the second comparison result 0, it indicates that more charges and higher remnant polarization Pr participate in ferroelectric polarization state switching, and that the remnant polarization Pr is enough to write 0 in the read phase. Therefore, the read voltage and the read pulse width upon outputting the first comparison result 1 for the first time may be selected as the read voltage and the read pulse width of the read phase.

This can ensure that the ferroelectric capacitor CFE meets a storage function, and can also ensure that there are enough charges participating in ferroelectric polarization state switching, and that the remnant polarization Pr is enough to write 0 in the read phase, to avoid excessively large remnant polarization Pr caused by an excessively high read voltage and/or an excessively large read pulse width. Therefore, the ferroelectric capacitor CFE is not damaged, and endurance of the ferroelectric capacitor CFE is not affected.

It should be noted herein that a step for increasing the read voltage and the read pulse width is not limited in this embodiment of this application. When the read voltage and the read pulse width are increased a plurality of times, the read voltage may be increased by using a same step, and the read pulse width may be increased by using a same step; or the read voltage may be increased by using different steps, and the read pulse width may be increased by using different steps. A specific example description may be the same as the example description of increasing the read voltage and the read pulse width in the foregoing embodiment, and details are not described herein again.

In addition, it should be noted that the foregoing two embodiments respectively describe a solution in which the comparison circuit 12 outputs the first comparison result 1 and the control circuit 13 controls the read voltage and/or the read pulse width on the bit line BL to decrease, and a solution in which the comparison circuit outputs the second comparison result 0 and the control circuit 13 controls the read voltage and/or the read pulse width on the bit line BL to increase. In some other possible implementations, the two solutions may alternatively be combined to determine a more appropriate read voltage and/or the read pulse width, so that the remnant polarization of the ferroelectric capacitor CFE is enough to enable the ferroelectric capacitor CFE to work normally. In addition, the ferroelectric capacitor CFE is not damaged due to excessively high remnant polarization of the ferroelectric capacitor CFE.

Specifically, the manner in the foregoing embodiment is still used to write the first digital signal 0 in the write phase, and write the second digital signal 1 in the read phase. If the comparison circuit 12 inputs the first comparison result 1 to the control circuit 13, the read voltage V1 and/or the read pulse width t1 may be gradually decreased until the comparison circuit 12 inputs the second comparison result 0 to the control circuit 13. In this way, the read voltage V1 and/or the read pulse width t1 upon outputting the second comparison result 0 by the comparison circuit 12 is compared with the previous read voltage V1 and/or the previous read pulse width t1, and a step is a first step. Then, the read voltage V1 and/or the read pulse width t1 may be gradually increased by using a second step until the comparison circuit 12 inputs the first comparison result 1 to the control circuit 13. The control circuit 13 selects, as a read pulse width and/or a read voltage in the read phase, a read voltage V1 and/or a read pulse width t1 upon reception of the first comparison result 1 this time. The first step is greater than the second step. That is, the first step used to decrease the read voltage V1 is greater than the second step used to increase the read voltage V1, and the first step used to decrease the read pulse width t1 is greater than the second step used to increase the read pulse width t1.

Alternatively, the first digital signal 0 is still written in the write phase, and the second digital signal 1 is still written in the read phase in the manner in the foregoing embodiment. If the comparison circuit 12 inputs the second comparison result 0 to the control circuit 13, the read voltage V1 and/or the read pulse width t1 may be gradually increased until the comparison circuit 12 inputs the first comparison result 1 to the control circuit 13. In this way, the read voltage V1 and/or the read pulse width t1 upon outputting the first comparison result 1 by the comparison circuit 12 is compared with the previous read voltage V1 and/or the previous read pulse width t1, and a step is a first step. Then, the read voltage V1 and/or the read pulse width t1 may be gradually decreased by using a second step until the comparison circuit 12 inputs the second comparison result 0 to the control circuit 13. The control circuit 13 selects, as a read pulse width and/or a read voltage of the read phase, a read voltage V1 and/or a read pulse width t1 previous to reception of the second comparison result 0 this time. The first step is greater than the second step. That is, the first step used to increase the read voltage V1 is greater than the second step used to decrease the read voltage V1, and the first step used to increase the read pulse width t1 is greater than the second step used to decrease the read pulse width t1.

The foregoing embodiment describes a case in which whether reading is sufficient in the read phase is detected. In another embodiment, when the circuit structure of the integrated circuit remains unchanged, whether writing is sufficient in the write phase may be further detected, to ensure that the ferroelectric capacitor CFE works normally. In addition, the ferroelectric capacitor CFE is not damaged due to excessively high remnant polarization Pr of the ferroelectric capacitor CFE. Assuming that an initial write state of the ferroelectric memory unit 11 is the second digital signal, and a state in the read phase is also the second digital signal, the first digital signal may be written between the initial write state and the read phase, so that a polarization state of the ferroelectric memory unit 11 is switched in an opposite electric field.

Specifically, as shown in FIG. 3a and FIG. 3b, the ferroelectric memory unit 11 is configured to: sequentially write a second digital signal and a first digital signal in a write phase, write the second digital signal in a read phase, switch a polarization state of the ferroelectric memory unit 11 in the read phase, to obtain a target voltage, and input the target voltage to the comparison circuit, where the first digital signal is different from the second digital signal.

The comparison circuit 12 is configured to: compare the target voltage with a reference voltage, and if the target voltage is greater than the reference voltage, input a first comparison result to the control circuit 13.

The control circuit 13 is configured to: receive the first comparison result, control the ferroelectric memory unit 11 to repeat the write phase and the read phase, gradually decrease, until a second comparison result that is input by the comparison circuit 12 and that indicates that the target voltage is less than or equal to the reference voltage is received, a write pulse width and/or a write voltage for writing the first digital signal in the write phase, and select a write pulse width and/or a write voltage previous to reception of the second comparison result for the first time as a write pulse width and/or a write voltage for writing the first digital signal in the write phase.

In some possible implementations, the ferroelectric memory unit 11 may include a transistor and a ferroelectric capacitor CFE that are electrically connected. A quantity of transistors and a quantity of ferroelectric capacitors CFE are not limited in embodiments of this application. The ferroelectric memory unit 11 may include one transistor and one ferroelectric capacitor CFE, or may include a plurality of transistors and a plurality of ferroelectric capacitors CFE. The transistor may include a P-type transistor and/or an N-type transistor.

In some possible implementations, the integrated circuit may further include a word line WL, a bit line BL, and a plate line PL. Potentials of the word line WL, the bit line BL, and the plate line PL may be controlled to write the first digital signal into the ferroelectric memory unit 11 in the write phase and write the second digital signal into the ferroelectric memory unit 11 in the read phase. The word line WL is electrically connected to a gate of the transistor, the bit line BL is electrically connected to a first electrode of the transistor, and the plate line PL is electrically connected to a second electrode of the transistor.

In addition, a connection relationship between the ferroelectric memory unit and each of the word line WL, the bit line BL, and the plate line PL, and explanations and descriptions of the first comparison result, the second comparison result, and the like in this embodiment of this application are the same as those in the foregoing embodiment. Details are not described herein again.

The following uses an example of detecting whether writing is sufficient in the write phase to describe a working principle of the integrated circuit provided in this embodiment of this application.

In a first case, refer to the circuit structure of the integrated circuit shown in FIG. 3a. Based on the foregoing circuit connection relationship, the bit line BL is further electrically connected to an input end of the comparison circuit 12. The first digital signal may be 1, and the second digital signal may be 0.

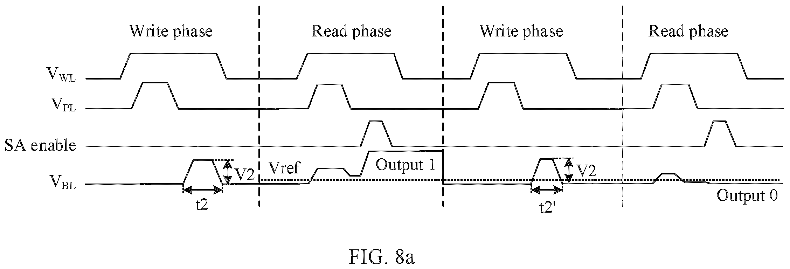

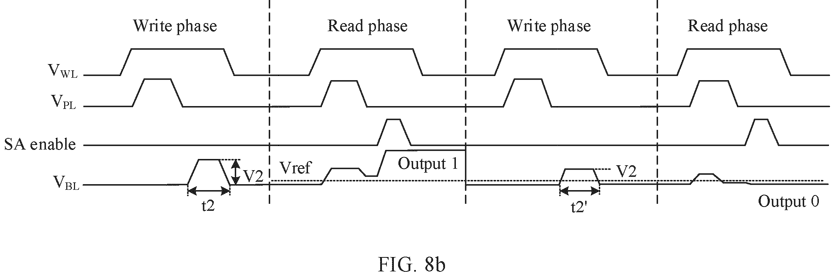

As shown in FIG. 8a and FIG. 8b, in the write phase, the potential on the word line WL is at a high level, and the transistor is conducted. The potential on the bit line BL is at a low level, and the potential on the plate line PL is at a high level. A charge on the plate line PL is written into the ferroelectric capacitor CFE through the transistor, to be specific, the second digital signal 0 is written into the ferroelectric capacitor CFE. Then, the potential on the bit line BL is at a high level, and the potential on the plate line PL is at a low level. A charge on the bit line BL is written into the ferroelectric capacitor CFE through the transistor, to be specific, the first digital signal 1 is written into the ferroelectric capacitor CFE.

Still refer to FIG. 8a and FIG. 8b. In the read phase, the potential on the word line WL is at a high level, and the transistor is conducted. The potential on the plate line PL is at a high level, and the potential on the bit line BL is at a low level. A charge on the plate line PL is written into the ferroelectric capacitor CFE through the transistor, to be specific, the second digital signal 0 is written into the ferroelectric capacitor CFE, to read the charge in the ferroelectric capacitor CFE to the bit line BL. As shown in FIG. 8a and FIG. 8b, after the voltage on the plate line PL is removed, the voltage on the bit line BL increases.

In the write phase, directions of electric fields applied to the ferroelectric capacitor CFE are opposite. Therefore, the polarization state of the ferroelectric capacitor CFE is switched, and a total quantity of read charges Q=2PrAMFM. Pr represents remnant polarization of the ferroelectric capacitor CFE, and AMFM represents an area of an overlapping region of the first electrode layer, the second electrode layer, and the ferroelectric functional layer.

It can be learned according to the formula Q=2PrAMFM that the remnant polarization Pr of the ferroelectric capacitor CFE is related to a total quantity Q of charges generated when the first digital signal 1 is written in the write phase. A larger total quantity Q of charges generated when the first digital signal 1 is written indicates larger remnant polarization Pr of the ferroelectric capacitor CFE. On the contrary, a smaller total quantity Q of charges generated when the first digital signal 1 is written indicates smaller remnant polarization Pr of the ferroelectric capacitor CFE.

Still refer to FIG. 8a and FIG. 8b. The charge written into the ferroelectric capacitor CFE in the write phase may be input to the input end of the comparison circuit 12 through the bit line BL in the read phase.

In some possible implementations, as shown in FIG. 3a, the integrated circuit may further include a first capacitor C1, and the first capacitor C1 is electrically connected to the input end of the comparison circuit 12 and the bit line BL. The first capacitor C1 is configured to receive and store a charge released when polarization of the ferroelectric capacitor CFE is switched. When the comparison circuit 12 is enabled, the first capacitor C1 inputs the stored charge to the comparison circuit 12 in a voltage form. In other words, the first capacitor C1 inputs the target voltage to the comparison circuit 12. The target voltage may be a voltage change value $\Delta V_{BL}$ of the bit line BL after removing of the voltage on the plate line PL in the read phase. According to a formula among a capacitance, a voltage, and a charge, the voltage change value

$$\Delta V_{BL} = \frac{2PrA_{MFM}}{C_1}$$ of the bit line BL after removing of the voltage on the plate line PL can be obtained, where C1 represents a capacitance value of the first capacitor C1, and the voltage change value $\Delta V_{BL}$ of the bit line BL is a storage window of the ferroelectric capacitor CFE, and represents a difference between a voltage on the bit line BL after removing of the voltage on the plate line PL in the read phase and an initial voltage on the bit line BL in the read phase.

After being enabled, the comparison circuit 12 may compare the received target voltage $\Delta V_{BL}$ with the reference voltage Vref. If the target voltage $\Delta V_{BL}$ is greater than the reference voltage Vref, the comparison circuit 12 outputs the first comparison result 1, to indicate that there are enough charges participating in ferroelectric polarization state switching, and that the remnant polarization Pr is enough to write the first digital signal 1 in the write phase. If the target voltage $\Delta V_{BL}$ is less than or equal to the reference voltage Vref, the comparison circuit 12 outputs the second comparison result 0, to indicate that there are not enough charges participating in ferroelectric polarization state switching, and that the remnant polarization Pr is not enough to write the first digital signal 1 in the write phase.

However, as mentioned above, when the remnant polarization Pr is enough to write the first digital signal 1 in the write phase, if the remnant polarization Pr is excessively large, a defect like a new oxygen vacancy is inevitably introduced, and the ferroelectric capacitor CFE is damaged. Therefore, when the remnant polarization Pr is enough to write the first digital signal 1 in the write phase, the remnant polarization Pr of the ferroelectric capacitor CFE may be reduced as much as possible, to prolong endurance of the ferroelectric capacitor CFE.

It can be learned according to the formula Q=2PrAMFM that remnant polarization Pr is positively correlated with a total quantity Q of charges read in the read phase, and the write pulse width and/or the write voltage for writing the first digital signal 1 in the write phase determine a total quantity Q of charges generated when the first digital signal 1 is written in the write phase. Therefore, in this embodiment of this application, the write voltage and the write pulse width for writing the first digital signal 1 in the write phase may be adjusted, to prolong endurance of the ferroelectric capacitor CFE.

Specifically, as shown in FIG. 8a and FIG. 8b, the second digital signal 0 and the first digital signal 1 may be sequentially written. A write voltage for writing the first digital signal 1 may be V2, and a write pulse width may be t2. Then, the second digital signal 0 is written in the read phase. After being enabled, the comparison circuit 12 compares the received target voltage $\Delta V_{BL}$ with the reference voltage Vref, and then inputs the first comparison result 1 to the control circuit 13. To avoid damage to the ferroelectric capacitor CFE due to excessively high remnant polarization Pr resulting from the current write voltage V2 and the current write pulse width t2, the second digital signal 0 and the first digital signal 1 continue to be sequentially written in the write phase, and the control circuit 13 controls the write voltage V2 for writing the first digital signal 1 to decrease to a write voltage V2' and/or the control circuit 13 controls the write pulse width t2 for writing the first digital signal 1 to decrease to a write pulse width t2', to perform a write operation of writing the first digital signal 1 based on the write voltage V2' and the write pulse width t2', or the write voltage V2' and the write pulse width t2, or the write voltage V2 and the write pulse width t2'. If the comparison circuit 12 inputs the second comparison result 0 to the control circuit 13, the previous write voltage V2 and the previous write pulse width t2 are selected as the write voltage and the write pulse width for writing the first digital signal 1 in the write phase; and if the comparison circuit 12 still inputs the first comparison result 1 to the control circuit 13, the foregoing write and read operations are still repeated, and the control circuit 13 controls the write voltage V2' and/or the write pulse width t2' to gradually decrease until the comparison circuit 12 inputs the second comparison result 0 to the control circuit 13, and selects, as a write voltage and a write pulse width for writing the first digital signal 1 in the write phase, a write voltage V2' and a write pulse width t2' (or a write voltage V2' and a write pulse width t2, or a write voltage V2 and a write pulse width t2') previous to outputting the second comparison result 0 by the comparison circuit 12.

Because the control circuit 13 controls the write voltage V2' and/or the write pulse width t2' for writing the first digital signal 1 in the write phase to gradually decrease, the next write voltage V2' and/or the next write pulse width t2' are/is always less than the previous write voltage V2' and/or the previous write pulse width t2' (or the write voltage V2 and/or the write pulse width t2). Therefore, the remnant polarization Pr of the ferroelectric capacitor CFE gradually decreases. In addition, because the comparison circuit 12 outputs the second comparison result 0 after outputting the first comparison result 1, it indicates that fewer charges and lower remnant polarization Pr participate in ferroelectric polarization state switching, and that the remnant polarization Pr is not enough to write 0 in the read phase. Therefore, the write voltage V2' and the write pulse width t2' (or the write voltage V2' and the write pulse width t2, or the write voltage V2 and the write pulse width t2') previous to outputting the second comparison result 0 by the comparison circuit 12 are selected as the write voltage and the write pulse width for writing the first digital signal 1 in the write phase.

In this way, the write voltage and the write pulse width for writing the first digital signal in the write phase can ensure that there are enough charges participating in ferroelectric polarization state switching, and that the remnant polarization Pr is enough to write 0 in the read phase. This can further avoid excessively large remnant polarization Pr caused by an excessively large write voltage and/or an excessively large write pulse width. Therefore, the ferroelectric capacitor CFE is not damaged, and endurance of the ferroelectric capacitor CFE is not affected.

It should be noted herein that, in this embodiment of this application, a step for decreasing the write voltage and the write pulse width for writing the first digital signal 1 in the write phase is not limited. When the write voltage and the write pulse width for writing the first digital signal 1 in the write phase are decreased a plurality of times, the write voltage for writing the first digital signal 1 in the write phase may be decreased by using a same step, and the write pulse width for writing the first digital signal 1 in the write phase may be decreased by using a same step. Alternatively, the write voltage for writing the first digital signal 1 in the write phase may be decreased by using different steps, and the write pulse width for writing the first digital signal 1 in the write phase may be decreased by using different steps. A specific example description may be the same as the example description of decreasing the read voltage and the read pulse width in the foregoing embodiment, and details are not described herein again.

The foregoing embodiment illustrates a case in which writing is sufficient and the remnant polarization Pr is excessively large upon detection of whether reading is sufficient in the write phase. In some other embodiments, upon detection of whether writing is sufficient in the write phase, the comparison circuit 12 may further output the second comparison result 0, to indicate that there are not enough charges participating in ferroelectric polarization state switching, and that the remnant polarization Pr is not enough to write the first digital signal 1 in the write phase.

In this case, this application may further disclose another embodiment. In this embodiment, the write voltage and the write pulse width for writing the first digital signal 1 in the write phase may also be adjusted. The remnant polarization of the ferroelectric capacitor CFE is improved, to ensure that the ferroelectric capacitor CFE can work normally. In addition, the ferroelectric capacitor CFE is not damaged due to excessively high remnant polarization of the ferroelectric capacitor CFE.

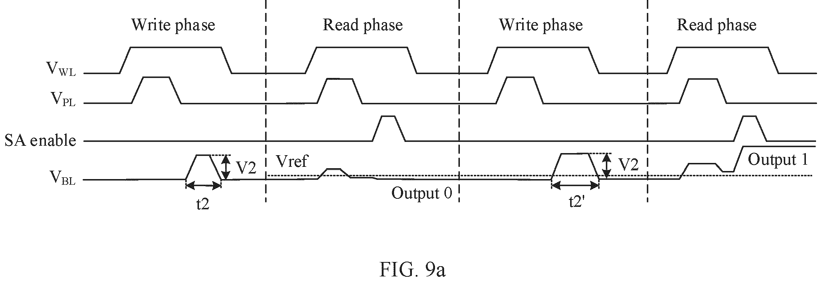

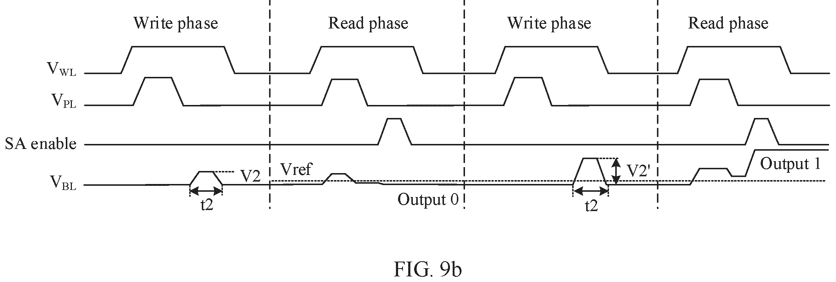

Specifically, as shown in FIG. 9a and FIG. 9b, the second digital signal 0 may be first written, and then the first digital signal 1 is written. A write voltage for writing the first digital signal may be V2, and a write pulse width for writing the first digital signal 1 may be t2. Then, the second digital signal 0 is written in the read phase. After being enabled, the comparison circuit 12 compares the received target voltage $\Delta V_{BL}$ with the reference voltage Vref, and then inputs the second comparison result 0 to the control circuit 13. Then, the ferroelectric capacitor CFE may work normally, and the first digital signal 1 continues to be written. The control circuit 13 controls the write voltage V2 to increase to a write voltage V2', and/or the control circuit 13 controls the write pulse width t2 to increase to a write pulse width t2', to perform a write operation of writing the first digital signal 1 based on the write voltage V2' and the write pulse width t2', or the write voltage V2' and the write pulse width t2, or the write voltage V2 and the write pulse width t2'. If the comparison circuit 12 inputs the first comparison result 1 to the control circuit 13, the current write voltage and the current write pulse width are selected as the write voltage and the write pulse width for writing the first digital signal 1 in the write phase; and if the comparison circuit 12 still inputs the second comparison result 0 to the control circuit 13, the foregoing write and read operations are still repeated, and the control circuit 13 controls the write voltage V2' and/or the write pulse width t2' to gradually increase until the comparison circuit 12 inputs the first comparison result 1 to the control circuit 13, and selects, as a write voltage and a write pulse width for writing the first digital signal 1 in the write phase, a write voltage and a write pulse width upon outputting the first comparison result 1 for the first time by the comparison circuit 12.

Because the control circuit 13 controls the write voltage V2' and/or the write pulse width t2' for writing the first digital signal 1 in the write phase to gradually increase, the next write voltage V2' and/or the next write pulse width t2' are/is always greater than the previous write voltage V2' and/or the previous write pulse width t2' (or the write voltage V2 and the write pulse width t2). Therefore, the remnant polarization Pr of the ferroelectric capacitor CFE gradually increases. In addition, because the comparison circuit 12 outputs the first comparison result 1 after outputting the second comparison result 0, it indicates that more charges and higher remnant polarization Pr participate in ferroelectric polarization state switching, and that the remnant polarization Pr is enough to write 0 in the read phase. Therefore, the write voltage and the write pulse width upon outputting the first comparison result 1 for the first time may be selected as the write voltage and the write pulse width for writing the first digital signal 1 in the write phase.

This can ensure that the ferroelectric capacitor CFE meets a storage function, and can also ensure that there are enough charges participating in ferroelectric polarization state switching, and that the remnant polarization Pr is enough to write the first digital signal 1 in the write phase, to avoid excessively large remnant polarization Pr caused by an excessively large write voltage and/or an excessively large write pulse width for writing the first digital signal 1. Therefore, the ferroelectric capacitor CFE is not damaged, and endurance of the ferroelectric capacitor CFE is not affected.

It should be noted herein that, in this embodiment of this application, a step for increasing the write voltage and the write pulse width for writing the first digital signal 1 in the write phase is not limited. When the write voltage and the write pulse width for writing the first digital signal 1 in the write phase are increased a plurality of times, the write voltage for writing the first digital signal 1 in the write phase may be increased by using a same step, and the write pulse width for writing the first digital signal 1 in the write phase may be increased by using a same step. Alternatively, the write voltage for writing the first digital signal 1 in the write phase may be increased by using different steps, and the write pulse width for writing the first digital signal 1 in the write phase may be increased by using different steps. A specific example description may be the same as the example description of increasing the read voltage and the read pulse width in the foregoing embodiment, and details are not described herein again.

In addition, it should be noted that the foregoing two embodiments respectively describe a solution in which the comparison circuit 12 outputs the first comparison result 1 and the control circuit 13 controls the write voltage and/or the write pulse width on the bit line BL to decrease, and a solution in which the comparison circuit outputs the second comparison result 0 and the control circuit 13 controls the write voltage and/or the write pulse width on the bit line BL to increase. In some other possible implementations, the two solutions may alternatively be combined to determine a more appropriate write voltage and/or write pulse width, so that the remnant polarization of the ferroelectric capacitor CFE is enough to enable the ferroelectric capacitor CFE to work normally. In addition, the ferroelectric capacitor CFE is not damaged due to excessively high remnant polarization of the ferroelectric capacitor CFE.

Specifically, the manner in the foregoing embodiment is still used to sequentially write the second digital signal 0 and the first digital signal 1 in the write phase, and write the second digital signal 0 in the read phase. If the comparison circuit 12 inputs the first comparison result 1 to the control circuit 13, the write voltage V2 and/or the write pulse width t2 for writing the first digital signal 1 in the write phase may be gradually decreased until the comparison circuit 12 inputs the second comparison result 0 to the control circuit 13. In this way, the write voltage V2

and/or the write pulse width t2 for writing the first digital signal 1 in the write phase upon outputting the second comparison result 0 by the comparison circuit 12 is compared with the previous write voltage V2 and/or the previous write pulse width t2 for writing the first digital signal 1 in the write phase, and a step is a first step. Then, the write voltage V2 and/or the write pulse width t2 for writing the first digital signal 1 in the write phase may be gradually increased by using a second step, until the comparison circuit 12 inputs the first comparison result 1 to the control circuit 13. The control circuit 13 selects, as a write pulse width and/or a write voltage for writing the first digital signal 1 in the write phase, a write voltage V2 and/or a write pulse width t2 upon reception of the first comparison result 1 this time. The first step is greater than the second step. That is, the first step used to decrease the write voltage V2 for writing the first digital signal 1 in the write phase is greater than the second step used to increase the write voltage V2 for writing the first digital signal 1 in the write phase, and the first step used to decrease the write pulse width t2 for writing the first digital signal 1 in the write phase is greater than the second step used to increase the write pulse width t2 for writing the first digital signal 1 in the write phase.

Alternatively, the manner in the foregoing embodiment is still used to sequentially write the second digital signal 0 and the first digital signal 1 in the write phase, and write the second digital signal 0 in the read phase. If the comparison circuit 12 inputs the second comparison result 0 to the control circuit 13, the write voltage V2 and/or the write pulse width t2 for writing the first digital signal 1 in the write phase may be gradually increased until the comparison circuit 12 inputs the first comparison result 1 to the control circuit 13. In this way, the write voltage V2 and/or the write pulse width t2 for writing the first digital signal 1 in the write phase upon outputting the first comparison result 1 by the comparison circuit 12 is compared with the previous write voltage V2 and/or the previous write pulse width t2 for writing the first digital signal 1 in the write phase, and a step is a first step. Then, the write voltage V2 and/or the write pulse width t2 for writing the first digital signal 1 in the write phase may be gradually decreased by using a second step, until the comparison circuit 12 inputs the second comparison result 0 to the control circuit 13. The control circuit 13 selects, as a write pulse width and/or a write voltage for writing the first digital signal 1 in the write phase, the write voltage V2 and/or the write pulse width t2 for writing the first digital signal 1 in the write phase previous to reception of the second comparison result 0 this time. The first step is greater than the second step. That is, the first step used to increase the write voltage V2 for writing the first digital signal 1 in the write phase is greater than the second step used to decrease the write voltage V2 for writing the first digital signal 1 in the write phase, and the first step used to increase the write pulse width t2 for writing the first digital signal 1 in the write phase is greater than the second step used to decrease the write pulse width t2 for writing the first digital signal 1 in the write phase.

In a second case, refer to the circuit structure of the integrated circuit shown in FIG. 3b. The plate line PL is further electrically connected to the input end of the comparison circuit 12. The first digital signal may be 0, and the second digital signal may be 1.

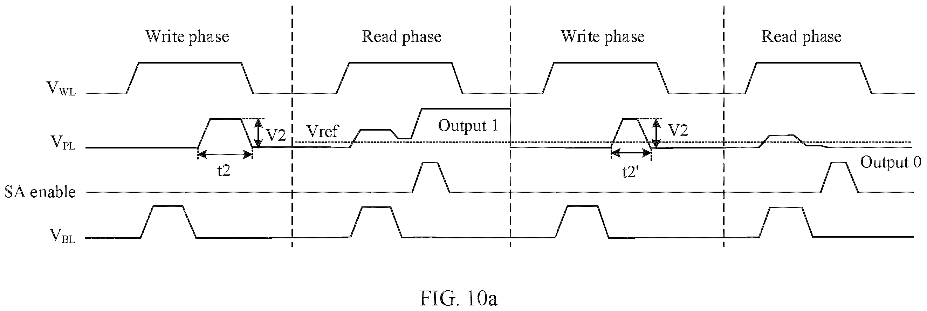

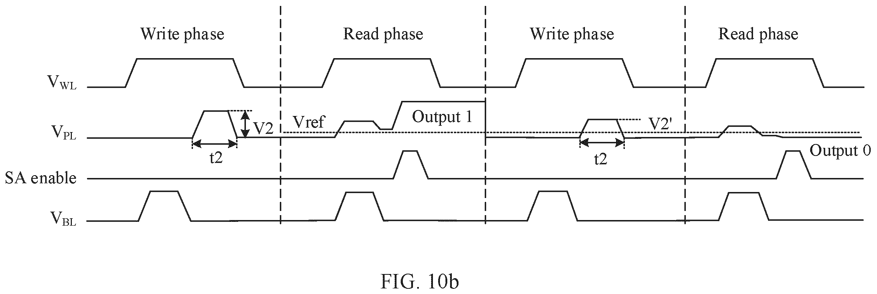

As shown in FIG. 10a and FIG. 10b, in the write phase, the potential on the word line WL is at a high level, and the transistor is conducted. The potential on the bit line BL is at a high level, and the potential on the plate line PL is at a low level. A charge on the bit line BL is written into the ferroelectric capacitor CFE through the transistor, to be specific, the second digital signal 1 is written into the ferroelectric capacitor CFE. Then, the potential on the bit line BL is at a low level, and the potential on the plate line PL is at a high level. A charge on the plate line PL is written into the ferroelectric capacitor CFE through the transistor, to be specific, the first digital signal 0 is written into the ferroelectric capacitor CFE.

Still refer to FIG. 10a and FIG. 10b. In the read phase, the potential on the word line WL is at a high level, and the transistor is conducted. The potential on the bit line BL is at a high level, the potential on the plate line PL is at a low level. A charge on the bit line BL is written into the ferroelectric capacitor CFE through the transistor, to be specific, the second digital signal 1 is written into the ferroelectric capacitor CFE, to read the charge in the ferroelectric capacitor CFE to the plate line PL. As shown in FIG. 10a and FIG. 10b, after a voltage on the bit line BL is removed, a voltage on the plate line PL increases.

In the write phase, directions of electric fields applied to the ferroelectric capacitor CFE are opposite. Therefore, the polarization state of the ferroelectric capacitor CFE is switched, and a total quantity of read charges Q=2PrAMFM. Pr represents remnant polarization of the ferroelectric capacitor CFE, and AMFM represents an area of an overlapping region of the first electrode layer, the second electrode layer, and the ferroelectric functional layer.

It can be learned according to the formula Q=2PrAMFM that the remnant polarization Pr of the ferroelectric capacitor CFE is related to a total quantity Q of charges generated when the first digital signal 0 is written in the write phase. A larger total quantity Q of charges generated when the first digital signal 0 is written indicates larger remnant polarization Pr of the ferroelectric capacitor CFE. On the contrary, a smaller total quantity Q of charges generated when the first digital signal 0 is written indicates smaller remnant polarization Pr of the ferroelectric capacitor CFE.

Still refer to FIG. 10a and FIG. 10b. The charge written into the ferroelectric capacitor CFE in the write phase may be input to the input end of the comparison circuit 12 through the plate line PL in the read phase.

In some possible implementations, as shown in FIG. 3b, the integrated circuit may further include a second capacitor C2, and the second capacitor C2 is electrically connected to the input end of the comparison circuit 12 and the bit line BL. The second capacitor C2 is configured to receive and store a charge released when polarization of the ferroelectric capacitor CFE is switched. When the comparison circuit 12 is enabled, the second capacitor C2 inputs the stored charge to the comparison circuit 12 in a voltage form. In other words, the second capacitor C2 inputs a target voltage to the comparison circuit 12. The target voltage may be a voltage change value ΔVPL of the plate line PL after removing of the voltage on the bit line BL in the read phase. According to a formula among a capacitance, a voltage, and a charge, the voltage change value

$$\Delta V_{PL} = \frac{2PrA_{MFM}}{C_2}$$ of the plate line PL after removing of the voltage on the bit line BL can be obtained, where C2 represents a capacitance value of the second capacitor C2, and the voltage change value ΔVPL of the plate line PL is a storage window of the ferroelectric capacitor CFE, and represents a difference between a voltage on the plate line PL after removing of the voltage on the bit line BL in the read phase and an initial voltage on the plate line PL in the read phase.

After being enabled, the comparison circuit 12 may compare the received target voltage ΔVPL with the reference voltage Vref. If the target voltage ΔVPL is greater than the reference voltage Vref, the comparison circuit 12 outputs the first comparison result 1, to indicate that there are enough charges participating in ferroelectric polarization state switching, and that the remnant polarization Pr is enough to write the first digital signal 0 in the write phase. If the target voltage ΔVPL is less than or equal to the reference voltage Vref, the comparison circuit 12 outputs the second comparison result 0, to indicate that there are not enough charges participating in ferroelectric polarization state switching, and that the remnant polarization Pr is not enough to write the first digital signal 0 in the write phase.

However, as mentioned above, when the remnant polarization Pr is enough to write the first digital signal 0 in the write phase, if the remnant polarization Pr is excessively large, a defect like a new oxygen vacancy is inevitably introduced, and the ferroelectric capacitor CFE is damaged. Therefore, when the remnant polarization Pr is enough to write the first digital signal 0 in the write phase, the remnant polarization Pr of the ferroelectric capacitor CFE may be reduced as much as possible, to prolong endurance of the ferroelectric capacitor CFE.

It can be learned according to the formula Q=2PrAMFM that remnant polarization Pr is positively correlated with a total quantity Q of charges generated when the first digital signal 0 is written in the write phase, and the write pulse width and/or the write voltage for writing the first digital signal 0 in the write phase determine the total quantity Q of charges generated when the first digital signal 0 is written in the write phase. Therefore, in this embodiment of this application, the write voltage and the write pulse width for writing the first digital signal 0 in the write phase may be adjusted, to prolong endurance of the ferroelectric capacitor CFE.

Specifically, as shown in FIG. 10a and FIG. 10b, the second digital signal 1 and the first digital signal 0 may be sequentially written. A write voltage for writing the first digital signal 0 may be V2, and a write pulse width may be t2. Then, the second digital signal 1 is written in the read phase. After being enabled, the comparison circuit 12 compares the received target voltage ΔVPL with the reference voltage Vref, and then inputs the first comparison result 1 to the control circuit 13. To avoid damage to the ferroelectric capacitor CFE due to excessively high remnant polarization Pr resulting from the current write voltage V2 and the current write pulse width t2, the second digital signal 1 and the first digital signal 0 continue to be sequentially written in the write phase, and the control circuit 13 controls the write voltage V2 for writing the first digital signal 0 to decrease to a write voltage V2' and/or the control circuit 13 controls the write pulse width t2 for writing the first digital signal 0 to decrease to a write pulse width t2', to perform a write operation of writing the first digital signal 0 based on the write voltage V2' and the write pulse width t2', or the write voltage V2' and the write pulse width t2, or the write voltage V2 and the write pulse width t2'. If the comparison circuit 12 inputs the second comparison result 0 to the control circuit 13, the previous write voltage V2 and the previous write pulse width t2 are selected as the write voltage and the write pulse width for writing the first digital signal 0 in the write phase; and if the comparison circuit 12 still inputs the first comparison result 1 to the control circuit 13, the foregoing write and read operations are still repeated, and the control circuit 13 controls the write voltage V2' and/or the write pulse width t2' to gradually decrease until the comparison circuit 12 inputs the second comparison result 0 to the control circuit 13, and selects, as a write voltage and a write pulse width for writing the first digital signal 0 in the write phase, a write voltage V2' and a write pulse width t2' (or a write voltage V2' and a write pulse width t2, or a write voltage V2 and a write pulse width t2') previous to outputting the second comparison result 0 by the comparison circuit 12.

Because the control circuit 13 controls the write voltage V2' and/or the write pulse width t2' for writing the first digital signal 0 in the write phase to gradually decrease, the next write voltage V2' and/or the next write pulse width t2' are/is always less than the previous write voltage V2' and/or the previous write pulse width t2' (or the write voltage V2 and/or the write pulse width t2). Therefore, the remnant polarization Pr of the ferroelectric capacitor CFE gradually decreases. In addition, because the comparison circuit 12 outputs the second comparison result 0 after outputting the first comparison result 1, it indicates that fewer charges and lower remnant polarization Pr participate in ferroelectric polarization state switching, and that the remnant polarization Pr is not enough to write 0 in the read phase. Therefore, the write voltage V2' and the write pulse width t2' (or the write voltage V2' and the write pulse width t2, or the write voltage V2 and the write pulse width t2') previous to outputting the second comparison result 0 by the comparison circuit 12 are selected as the write voltage and the write pulse width for writing the first digital signal 0 in the write phase.

In this way, the write voltage and the write pulse width for writing the first digital signal in the write phase can ensure that there are enough charges participating in ferroelectric polarization state switching, and that the remnant polarization Pr is enough to write 0 in the read phase. This can further avoid excessively large remnant polarization Pr caused by an excessively large write voltage and/or an excessively large write pulse width. Therefore, the ferroelectric capacitor CFE is not damaged, and endurance of the ferroelectric capacitor CFE is not affected.

It should be noted herein that, in this embodiment of this application, a step for decreasing the write voltage and the write pulse width for writing the first digital signal 0 in the write phase is not limited. When the write voltage and the write pulse width for writing the first digital signal 0 in the write phase are decreased a plurality of times, the write voltage for writing the first digital signal 0 in the write phase may be decreased by using a same step, and the write pulse width for writing the first digital signal 0 in the write phase may be decreased by using a same step. Alternatively, the write voltage for writing the first digital signal 0 in the write phase may be decreased by using different steps, and the write pulse width for writing the first digital signal 0 in the write phase may be decreased by using different steps. A specific example description may be the same as the example description of decreasing the read voltage and the read pulse width in the foregoing embodiment, and details are not described herein again.

The foregoing embodiment illustrates a case in which writing is sufficient and the remnant polarization Pr is excessively large upon detection of whether reading is sufficient in the write phase. In some other embodiments, upon detection of whether writing is sufficient in the write phase, the comparison circuit 12 may further output the second comparison result 0, to indicate that there are not enough charges participating in ferroelectric polarization state switching, and that the remnant polarization Pr is not enough to write the first digital signal 0 in the write phase.

In this case, this application may further disclose another embodiment. In this embodiment, the write voltage and the write pulse width for writing the first digital signal 0 in the write phase may also be adjusted. The remnant polarization of the ferroelectric capacitor CFE is improved, to ensure that the ferroelectric capacitor CFE can work normally. In addition, the ferroelectric capacitor CFE is not damaged due to excessively high remnant polarization of the ferroelectric capacitor CFE.

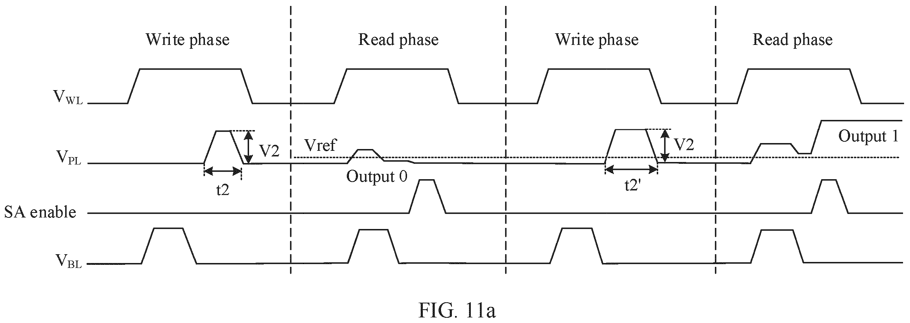

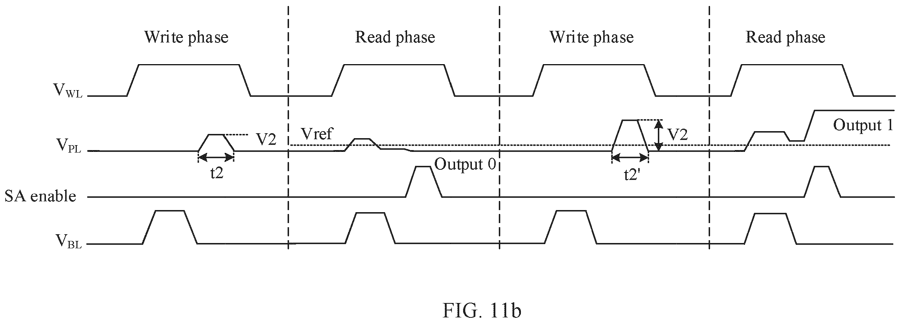

Specifically, as shown in FIG. 11a and FIG. 11b, the second digital signal 1 may be first written, and then the first digital signal 0 is written. A write voltage for writing the first digital signal may be V2, and a write pulse width for writing the first digital signal 0 may be t2. Then, the second digital signal 1 is written in the read phase. After being enabled, the comparison circuit 12 compares the received target voltage ΔVPL with the reference voltage Vref, and then inputs the second comparison result 0 to the control circuit 13. Then, the ferroelectric capacitor CFE may work normally, and the first digital signal 0 continues to be written. The control circuit 13 controls the write voltage V2 to increase to a write voltage V2', and/or the control circuit 13 controls the write pulse width t2 to increase to a write pulse width t2', to perform a write operation of writing the first digital signal based on the write voltage V2' and the write pulse width t2', or the write voltage V2' and the write pulse width t2, or the write voltage V2 and the write pulse width t2'. If the comparison circuit 12 inputs the first comparison result 1 to the control circuit 13, the current write voltage and the current write pulse width are selected as the write voltage and the write pulse width for writing the first digital signal 0 in the write phase; and if the comparison circuit 12 still inputs the second comparison result 0 to the control circuit 13, the foregoing write and read operations are still repeated, and the control circuit 13 controls the write voltage V2' and/or the write pulse width t2' to gradually increase until the comparison circuit 12 inputs the first comparison result 1 to the control circuit 13, and selects, as a write voltage and a write pulse width for writing the first digital signal 0 in the write phase, a write voltage and a write pulse width upon outputting the first comparison result 1 for the first time by the comparison circuit 12.

Because the control circuit 13 controls the write voltage V2' and/or the write pulse width t2' for writing the first digital signal 0 in the write phase to gradually increase, the next write voltage V2' and/or the next write pulse width t2' are/is always greater than the previous write voltage V2' and/or the previous write pulse width t2' (or the write voltage V2 and the write pulse width t2). Therefore, the remnant polarization Pr of the ferroelectric capacitor CFE gradually increases. In addition, because the comparison circuit 12 outputs the first comparison result 1 after outputting the second comparison result 0, it indicates that more charges and higher remnant polarization Pr participate in ferroelectric polarization state switching, and that the remnant polarization Pr is enough to write 0 in the read phase. Therefore, the write voltage and the write pulse width upon outputting the first comparison result 1 for the first time may be selected as the write voltage and the write pulse width for writing the first digital signal 0 in the write phase.

This can ensure that the ferroelectric capacitor CFE meets a storage function, and can also ensure that there are enough charges participating in ferroelectric polarization state switching, and that the remnant polarization Pr is enough to write the first digital signal 0 in the write phase, to avoid excessively large remnant polarization Pr caused by an excessively large write voltage and/or an excessively large write pulse width for writing the first digital signal 0. Therefore, the ferroelectric capacitor CFE is not damaged, and endurance of the ferroelectric capacitor CFE is not affected.

It should be noted herein that, in this embodiment of this application, a step for increasing the write voltage and the write pulse width for writing the first digital signal 0 in the write phase is not limited. When the write voltage and the write pulse width for writing the first digital signal 0 in the write phase are increased a plurality of times, the write voltage for writing the first digital signal 0 in the write phase may be increased by using a same step, and the write pulse width for writing the first digital signal 0 in the write phase may be increased by using a same step. Alternatively, the write voltage for writing the first digital signal 0 in the write phase may be increased by using different steps, and the write pulse width for writing the first digital signal 0 in the write phase may be increased by using different steps. A specific example description may be the same as the example description of increasing the read voltage and the read pulse width in the foregoing embodiment, and details are not described herein again.

In addition, it should be noted that the foregoing two embodiments respectively describe a solution in which the comparison circuit 12 outputs the first comparison result 1 and the control circuit 13 controls the write voltage and/or the write pulse width on the bit line BL to decrease, and a solution in which the comparison circuit outputs the second comparison result 0 and the control circuit 13 controls the write voltage and/or the write pulse width on the bit line BL to increase. In some other possible implementations, the two solutions may alternatively be combined to determine a more appropriate write voltage and/or write pulse width, so that the remnant polarization of the ferroelectric capacitor CFE is enough to enable the ferroelectric capacitor CFE to work normally. In addition, the ferroelectric capacitor CFE is not damaged due to excessively high remnant polarization of the ferroelectric capacitor CFE.

Specifically, the manner in the foregoing embodiment is still used to sequentially write the second digital signal 1 and the first digital signal 0 in the write phase, and write the second digital signal 1 in the read phase. If the comparison circuit 12 inputs the first comparison result 1 to the control circuit 13, the write voltage V2 and/or the write pulse width t2 for writing the first digital signal 0 in the write phase may be gradually decreased until the comparison circuit 12 inputs the second comparison result 0 to the control circuit 13. In this way, the write voltage V2 and/or the write pulse width t2 for writing the first digital signal 0 in the write phase upon outputting the second comparison result 0 by the comparison circuit 12 is compared with the previous write voltage V2 and/or the previous write pulse width t2 for writing the first digital signal 0 in the write phase, and a step is a first step. Then, the write voltage V2 and/or the write pulse width t2 for writing the first digital signal 0 in the write phase may be gradually increased by using a second step until the comparison circuit 12 inputs the first comparison result 1 to the control circuit 13. The control circuit 13 selects, as a write pulse width and/or a write voltage for writing the first digital signal 0 in the write phase, a write voltage V2 and/or a write pulse width t2 upon reception of the first comparison result 1 this time. The first step is greater than the second step. That is, the first step used to decrease the write voltage V2 for writing the first digital signal 0 in the write phase is greater than the second step used to increase the write voltage V2 for writing the first digital signal 0 in the write phase, and the first step used to decrease the write pulse width t2 for writing the first digital signal 0 in the write phase is greater than the second step used to increase the write pulse width t2 for writing the first digital signal 0 in the write phase.

Alternatively, the manner in the foregoing embodiment is still used to sequentially write the second digital signal 1 and the first digital signal 0 in the write phase, and write the second digital signal 1 in the read phase. If the comparison circuit 12 inputs the second comparison result 0 to the control circuit 13, the write voltage V2 and/or the write pulse width t2 for writing the first digital signal 0 in the write phase may be gradually increased until the comparison circuit 12 inputs the first comparison result 1 to the control circuit 13. In this way, the write voltage V2 and/or the write pulse width t2 for writing the first digital signal 0 in the write phase upon outputting the first comparison result 1 by the comparison circuit 12 is compared with the previous write voltage V2 and/or the previous write pulse width t2 for writing the first digital signal 0 in the write phase, and a step is a first step. Then, the write voltage V2 and/or the write pulse width t2 for writing the first digital signal 0 in the write phase may be gradually decreased by using a second step, until the comparison circuit 12 inputs the second comparison result 0 to the control circuit 13. The control circuit 13 selects, as a write pulse width and/or a write voltage for writing the first digital signal 0 in the write phase, a write voltage V2 and/or a write pulse width t2 for writing the first digital signal 0 in the write phase previous to reception of the second comparison result 0 this time. The first step is greater than the second step. That is, the first step used to increase the write voltage V2 for writing the first digital signal 0 in the write phase is greater than the second step used to decrease the write voltage V2 for writing the first digital signal 0 in the write phase, and the first step used to increase the write pulse width t2 for writing the first digital signal 0 in the write phase is greater than the second step used to decrease the write pulse width t2 for writing the first digital signal 0 in the write phase.

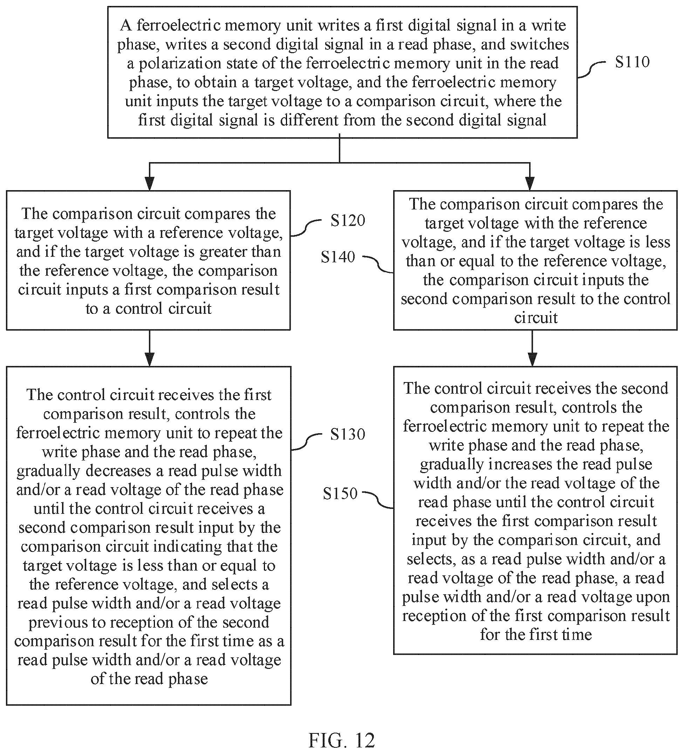

In still another embodiment, as shown in FIG. 12, this application further provides a control method of an integrated circuit. The integrated circuit may include the ferroelectric memory unit 11, the comparison circuit 12, and the control circuit 13. The read voltage and the read pulse width of the read phase can ensure that there are enough charges participating in ferroelectric polarization state switching, and that the remnant polarization Pr is enough to write 0 in the read phase. This can further avoid excessively large remnant polarization Pr caused by an excessively high read voltage and/or an excessively large read pulse width. Therefore, the ferroelectric memory unit 11 is not damaged, and endurance of the ferroelectric memory unit 11 is not affected.

S110: The ferroelectric memory unit 11 writes a first digital signal in a write phase, writes a second digital signal in a read phase, and switches a polarization state of the ferroelectric memory unit 11 in the read phase, to obtain a target voltage, and the ferroelectric memory unit inputs the target voltage to the comparison circuit 12, where the first digital signal is different from the second digital signal.

S120: The comparison circuit 12 compares the target voltage with a reference voltage, and if the target voltage is greater than the reference voltage, the comparison circuit 12 inputs a first comparison result to the control circuit 13.

S130: The control circuit 13 receives the first comparison result, controls the ferroelectric memory unit 11 to repeat the write phase and the read phase, gradually decreases a read pulse width and/or a read voltage of the read phase until the control circuit 13 receives a second comparison result that is input by the comparison circuit 12 and that indicates that the target voltage is less than or equal to the reference voltage, and selects a read pulse width and/or a read voltage previous to reception of the second comparison result for the first time as a read pulse width and/or a read voltage of the read phase.

On this basis, after the target voltage is input to the comparison circuit 12, the control method of the integrated circuit may further include:

S140: The comparison circuit 12 compares the target voltage with the reference voltage, and if the target voltage is less than or equal to the reference voltage, the comparison circuit 12 inputs the second comparison result to the control circuit 13.

S150: The control circuit 13 receives the second comparison result, controls the ferroelectric memory unit 11 to repeat the write phase and the read phase, gradually increases the read pulse width and/or the read voltage of the read phase until the control circuit 13 receives the first comparison result input by the comparison circuit 12, and selects, as the read pulse width and/or the read voltage of the read phase, a read pulse width and/or a read voltage upon reception of the first comparison result for the first time.

This can ensure that the ferroelectric memory unit 11 meets a storage function, and can also ensure that there are enough charges participating in ferroelectric polarization state switching, and that the remnant polarization Pr is enough to write 0 in the read phase, to avoid excessively large remnant polarization Pr caused by an excessively high read voltage and/or an excessively large read pulse width. Therefore, the ferroelectric memory unit 11 is not damaged, and endurance of the ferroelectric capacitor CFE is not affected.

The control method of the integrated circuit in this embodiment of this application is the same as a working principle of the integrated circuit corresponding to FIG. 3a in any one of the foregoing embodiments. Details are not described herein again.

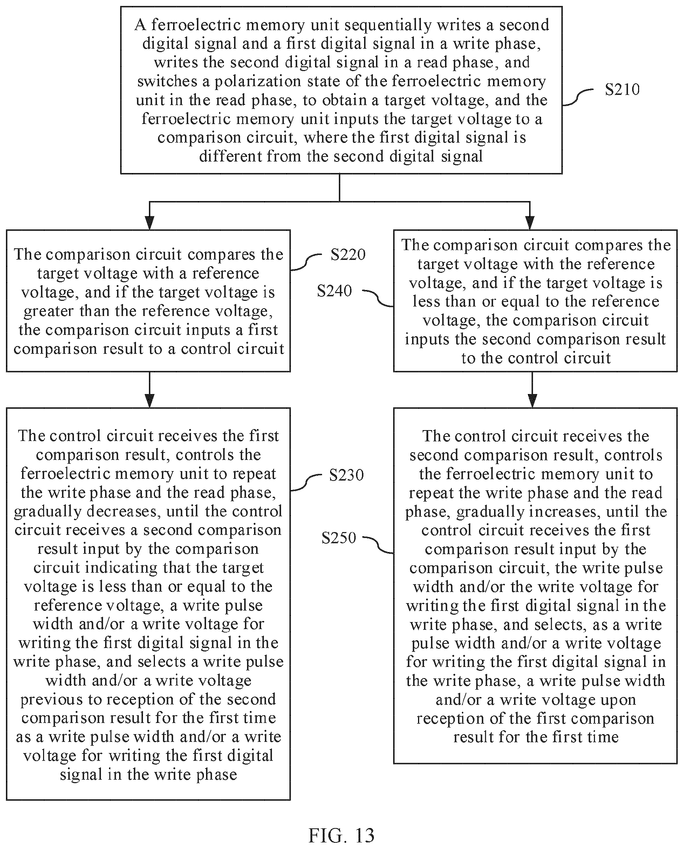

In still another embodiment, as shown in FIG. 13, this application further provides a control method of an integrated circuit. The integrated circuit may include the ferroelectric memory unit 11, the comparison circuit 12, and the control circuit 13. The read voltage and the read pulse width of the read phase can ensure that there are enough charges participating in ferroelectric polarization state switching, and that the remnant polarization Pr is enough to write 0 in the read phase. This can further avoid excessively large remnant polarization Pr caused by an excessively high read voltage and/or an excessively large read pulse width. Therefore, the ferroelectric memory unit 11 is not damaged, and endurance of the ferroelectric memory unit 11 is not affected.

S210: The ferroelectric memory unit 11 sequentially writes a second digital signal and a first digital signal in a write phase, writes the second digital signal in a read phase, and switches a polarization state of the ferroelectric memory unit 11 in the read phase, to obtain a target voltage, and the ferroelectric memory unit 11 inputs the target voltage to the comparison circuit 12, where the first digital signal is different from the second digital signal.

S220: The comparison circuit 12 compares the target voltage with a reference voltage, and if the target voltage is greater than the reference voltage, the comparison circuit 12 inputs a first comparison result to the control circuit 13.

S230: The control circuit 13 receives the first comparison result, controls the ferroelectric memory unit 11 to repeat the write phase and the read phase, gradually decreases, until the control circuit 13 receives a second comparison result that is input by the comparison circuit 12 and that indicates that the target voltage is less than or equal to the reference voltage, a write pulse width and/or a write voltage for writing the first digital signal in the write phase, and selects a write pulse width and/or a write voltage previous to reception of the second comparison result for the first time as a write pulse width and/or a write voltage for writing the first digital signal in the write phase.

On this basis, after the target voltage is input to the comparison circuit 12, the control method of the integrated circuit may further include:

S240: The comparison circuit 12 compares the target voltage with the reference voltage, and if the target voltage is less than or equal to the reference voltage, the comparison circuit 12 inputs the second comparison result to the control circuit 13.

S250: The control circuit 13 receives the second comparison result, controls the ferroelectric memory unit 11 to repeat the write phase and the read phase, gradually increases, until the control circuit 13 receives the first comparison result input by the comparison circuit 12, the write pulse width and/or the write voltage for writing the first digital signal in the write phase, and selects, as the write pulse width and/or the write voltage for writing the first digital signal in the write phase, a write pulse width and/or a write voltage upon reception of the first comparison result for the first time.

The control method of the integrated circuit in this embodiment of this application is the same as a working principle of the integrated circuit corresponding to FIG. 3b in any one of the foregoing embodiments. Details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. An integrated circuit, comprising a ferroelectric memory unit, a comparison circuit, and a control circuit, wherein

   the ferroelectric memory unit is configured to: write a first digital signal in a write phase, write a second digital signal in a read phase, switch a polarization state of the ferroelectric memory unit in the read phase, to obtain a target voltage, and input the target voltage to the comparison circuit, wherein the first digital signal is different from the second digital signal;
   the comparison circuit is configured to: compare the target voltage with a reference voltage, and if the target voltage is greater than the reference voltage, input a first comparison result to the control circuit; and
   the control circuit is configured to: receive the first comparison result, control the ferroelectric memory unit to repeat the write phase and the read phase, gradually decrease a read pulse width and/or a read voltage of the read phase until a second comparison result input by the comparison circuit indicating that the target voltage is less than or equal to the reference voltage is received, and select a read pulse width and/or a read voltage previous to reception of the second comparison result for the first time as a read pulse width and/or a read voltage of the read phase.

2. The integrated circuit according to claim 1, wherein

the comparison circuit is further configured to input the second comparison result to the control circuit when the target voltage is greater than the reference voltage; and

the control circuit is further configured to: receive the second comparison result, control the ferroelectric memory unit to repeat the write phase and the read phase, gradually increase the read pulse width and/or the read voltage of the read phase until the first comparison result input by the comparison circuit is received, and select, as a read pulse width and/or a read voltage of the read phase, a read pulse width and/or a read voltage upon reception of the first comparison result for the first time.

3. The integrated circuit according to claim 1 or 2, wherein the ferroelectric memory unit comprises a transistor and a ferroelectric capacitor, and the integrated circuit further comprises a word line, a bit line, and a plate line; and

the word line is electrically connected to a gate of the transistor, the bit line is electrically connected to a first electrode of the transistor, and the plate line is electrically connected to a second electrode of the transistor.

4. The integrated circuit according to claim 3, wherein the first digital signal is 1, the second digital signal is 0, and the bit line is further electrically connected to an input end of the comparison circuit; and

when the transistor is conducted, if the bit line is at a high level and the plate line is at a low level, the ferroelectric capacitor is configured to write the first digital signal in the write phase; and if the plate line is at a high level and the bit line is at a low level, the ferroelectric capacitor is configured to write the second digital signal in the read phase.

5. The integrated circuit according to claim 4, wherein the integrated circuit further comprises a first capacitor, and the first capacitor is electrically connected to the input end of the comparison circuit and the bit line; and

the first capacitor is configured to: receive a charge released when polarization of the ferroelectric capacitor is switched, and output the received charge as the target voltage.

6. The integrated circuit according to claim 3, wherein the first digital signal is 0, the second digital signal is 1, and the plate line is further electrically connected to an input end of the comparison circuit; and

when the transistor is conducted, if the plate line is at a high level and the bit line is at a low level, the ferroelectric capacitor is configured to write the first digital signal in the write phase; and if the bit line is at a high level and the plate line is at a low level, the ferroelectric capacitor is configured to write the second digital signal in the read phase.

7. The integrated circuit according to claim 6, wherein the integrated circuit further comprises a second capacitor, and the second capacitor is electrically connected to the input end of the comparison circuit and the plate line; and

the second capacitor is configured to: receive a charge released when polarization of the ferroelectric capacitor is switched, and output the received charge as the target voltage.

8. An integrated circuit, comprising a ferroelectric memory unit, a comparison circuit, and a control circuit, wherein

the ferroelectric memory unit is configured to: sequentially write a second digital signal and a first digital signal in a write phase, write the second digital signal in a read phase, switch a polarization state of the ferroelectric memory unit in the read phase, to obtain a target voltage, and input the target voltage to the comparison circuit, wherein the first digital signal is different from the second digital signal;

the comparison circuit is configured to: compare the target voltage with a reference voltage, and if the target voltage is greater than the reference voltage, input a first comparison result to the control circuit; and

the control circuit is configured to: receive the first comparison result, control the ferroelectric memory unit to repeat the write phase and the read phase, gradually decrease, until a second comparison result input by the comparison circuit indicating that the target voltage is less than or equal to the reference voltage is received, a write pulse width and/or a write voltage for writing the first digital signal in the write phase, and select a write pulse width and/or a write voltage previous to reception of the second comparison result for the first time as a write pulse width and/or a write voltage for writing the first digital signal in the write phase.

9. The integrated circuit according to claim 8, wherein

the comparison circuit is further configured to input the second comparison result to the control circuit when the target voltage is greater than the reference voltage; and

the control circuit is further configured to: receive the second comparison result, control the ferroelectric memory unit to repeat the write phase and the read phase, gradually increase, until the first comparison result input by the comparison circuit is received, the write pulse width and/or the write voltage for writing the first digital signal in the write phase, and select, as a write pulse width and/or a write voltage for writing the first digital signal in the write phase, a write pulse width and/or a write voltage upon reception of the first comparison result for the first time.

10. The integrated circuit according to claim 8 or 9, wherein the ferroelectric memory unit comprises a transistor and a ferroelectric capacitor, and the integrated circuit further comprises a word line, a bit line, and a plate line; and
the word line is electrically connected to a gate of the transistor, the bit line is electrically connected to a first electrode of the transistor, and the plate line is electrically connected to a second electrode of the transistor.

11. The integrated circuit according to claim 10, wherein the first digital signal is 1, the second digital signal is 0, and the bit line is further electrically connected to an input end of the comparison circuit; and
when the transistor is conducted, if the plate line is at a high level and the bit line is at a low level, the ferroelectric capacitor is configured to write the second digital signal in the write phase and the read phase; and if the bit line is at a high level and the plate line is at a low level, the ferroelectric capacitor is configured to write the first digital signal in the write phase.

12. The integrated circuit according to claim 11, wherein the integrated circuit further comprises a first capacitor, and the first capacitor is electrically connected to the input end of the comparison circuit and the bit line; and
the first capacitor is configured to: receive a charge released when polarization of the ferroelectric capacitor is switched, and output the received charge as the target voltage.

13. The integrated circuit according to claim 10, wherein the first digital signal is 0, the second digital signal is 1, and the plate line is further electrically connected to an input end of the comparison circuit; and
when the transistor is conducted, if the bit line is at a high level and the plate line is at a low level, the ferroelectric capacitor is configured to write the second digital signal in the write phase and the read phase; and if the plate line is at a high level and the bit line is at a low level, the ferroelectric capacitor is configured to write the first digital signal in the write phase.

14. The integrated circuit according to claim 13, wherein the integrated circuit further comprises a second capacitor, and the second capacitor is electrically connected to the input end of the comparison circuit and the plate line; and
the second capacitor is configured to: receive a charge released when polarization of the ferroelectric capacitor is switched, and output the received charge as the target voltage.

15. A chip, comprising the integrated circuit according to any one of claims 1 to 7 or any one of claims 8 to 14.

16. A terminal, comprising a circuit board and the chip according to claim 15, wherein the chip is disposed on the circuit board.

17. A control method of an integrated circuit, wherein the integrated circuit comprises a ferroelectric memory unit, a comparison circuit, and a control circuit, and the control method of the integrated circuit comprises:

writing, by the ferroelectric memory unit, a first digital signal in a write phase, writing a second digital signal in a read phase, and switching a polarization state of the ferroelectric memory unit in the read phase, to obtain a target voltage, and inputting, by the ferroelectric memory unit, the target voltage to the comparison circuit, wherein the first digital signal is different from the second digital signal;
comparing, by the comparison circuit, the target voltage with a reference voltage, and if the target voltage is greater than the reference voltage, inputting, by the comparison circuit, a first comparison result to the control circuit; and
receiving, by the control circuit, the first comparison result, controlling the ferroelectric memory unit to repeat the write phase and the read phase, gradually decreasing a read pulse width and/or a read voltage of the read phase until the control circuit receives a second comparison result input by the comparison circuit indicating that the target voltage is less than or equal to the reference voltage, and selecting a read pulse width and/or a read voltage previous to reception of the second comparison result for the first time as a read pulse width and/or a read voltage of the read phase.

18. The control method of the integrated circuit according to claim 17, wherein after the inputting the target voltage to the comparison circuit, the control method of the integrated circuit further comprises:

comparing, by the comparison circuit, the target voltage with the reference voltage, and if the target voltage is less than or equal to the reference voltage, inputting, by comparison circuit, the second comparison result to the control circuit; and

receiving, by the control circuit, the second comparison result, controlling the ferroelectric memory unit to repeat the write phase and the read phase, gradually increasing the read pulse width and/or the read voltage of the read phase until the control circuit receives the first comparison result input by the comparison circuit, and selecting, as a read pulse width and/or a read voltage of the read phase, a read pulse width and/or a read voltage upon reception of the first comparison result for the first time.

19. A control method of an integrated circuit, wherein the integrated circuit comprises a ferroelectric memory unit, a comparison circuit, and a control circuit, and the control method of the integrated circuit comprises:

    sequentially writing, by the ferroelectric memory unit, a second digital signal and a first digital signal in a write phase, writing the second digital signal in a read phase, and switching a polarization state of the ferroelectric memory unit in the read phase, to obtain a target voltage, and inputting, by the ferroelectric memory unit, the target voltage to the comparison circuit, wherein the first digital signal is different from the second digital signal;

    comparing, by the comparison circuit, the target voltage with a reference voltage, and if the target voltage is greater than the reference voltage, inputting, by the comparison circuit, a first comparison result to the control circuit; and

    receiving, by the control circuit, the first comparison result, controlling the ferroelectric memory unit to repeat the write phase and the read phase, gradually decreasing, until the control circuit receives a second comparison result input by the comparison circuit indicating that the target voltage is less than or equal to the reference voltage, a write pulse width and/or a write voltage for writing the first digital signal in the write phase, and selecting a write pulse width and/or a write voltage previous to reception of the second comparison result for the first time as a write pulse width and/or a write voltage for writing the first digital signal in the write phase.

20. The control method of the integrated circuit according to claim 19, wherein after the inputting the target voltage to the comparison circuit, the control method of the integrated circuit further comprises:

comparing, by the comparison circuit, the target voltage with the reference voltage, and if the target voltage is less than or equal to the reference voltage, inputting, by the comparison circuit, the second comparison result to the control circuit; and

receiving, by the control circuit, the second comparison result, controlling the ferroelectric memory unit to repeat the write phase and the read phase, gradually increasing, until the control circuit receives the first comparison result input by the comparison circuit, the write pulse width and/or the write voltage for writing the first digital signal in the write phase, and selecting, as a write pulse width and/or a write voltage for writing the first digital signal in the write phase, a write pulse width and/or a write voltage upon reception of the first comparison result for the first time.

FIG. 1

FIG. 2

FIG. 3a

FIG. 3b

FIG. 4a

FIG. 4b

EP 4 564 353 A1

FIG. 4c

FIG. 5a

FIG. 5b

FIG. 6a

FIG. 6b

EP 4 564 353 A1

FIG. 7a

FIG. 7b

FIG. 8a

FIG. 8b

EP 4 564 353 A1

FIG. 9a

FIG. 9b

EP 4 564 353 A1

FIG. 10a

EP 4 564 353 A1

FIG. 10b

EP 4 564 353 A1

FIG. 11a

FIG. 11b

EP 4 564 353 A1

A ferroelectric memory unit writes a first digital signal in a write phase, writes a second digital signal in a read phase, and switches a polarization state of the ferroelectric memory unit in the read phase, to obtain a target voltage, and the ferroelectric memory unit inputs the target voltage to a comparison circuit, where the first digital signal is different from the second digital signal — S110

The comparison circuit compares the target voltage with a reference voltage, and if the target voltage is greater than the reference voltage, the comparison circuit inputs a first comparison result to a control circuit — S120

The comparison circuit compares the target voltage with the reference voltage, and if the target voltage is less than or equal to the reference voltage, the comparison circuit inputs the second comparison result to the control circuit — S140

The control circuit receives the first comparison result, controls the ferroelectric memory unit to repeat the write phase and the read phase, gradually decreases a read pulse width and/or a read voltage of the read phase until the control circuit receives a second comparison result input by the comparison circuit indicating that the target voltage is less than or equal to the reference voltage, and selects a read pulse width and/or a read voltage previous to reception of the second comparison result for the first time as a read pulse width and/or a read voltage of the read phase — S130

The control circuit receives the second comparison result, controls the ferroelectric memory unit to repeat the write phase and the read phase, gradually increases the read pulse width and/or the read voltage of the read phase until the control circuit receives the first comparison result input by the comparison circuit, and selects, as a read pulse width and/or a read voltage of the read phase, a read pulse width and/or a read voltage upon reception of the first comparison result for the first time — S150

FIG. 12

A ferroelectric memory unit sequentially writes a second digital signal and a first digital signal in a write phase, writes the second digital signal in a read phase, and switches a polarization state of the ferroelectric memory unit in the read phase, to obtain a target voltage, and the ferroelectric memory unit inputs the target voltage to a comparison circuit, where the first digital signal is different from the second digital signal ⟋ S210

The comparison circuit compares the target voltage with a reference voltage, and if the target voltage is greater than the reference voltage, the comparison circuit inputs a first comparison result to a control circuit ⟋ S220

The comparison circuit compares the target voltage with the reference voltage, and if the target voltage is less than or equal to the reference voltage, the comparison circuit inputs the second comparison result to the control circuit

S240

The control circuit receives the first comparison result, controls the ferroelectric memory unit to repeat the write phase and the read phase, gradually decreases, until the control circuit receives a second comparison result input by the comparison circuit indicating that the target voltage is less than or equal to the reference voltage, a write pulse width and/or a write voltage for writing the first digital signal in the write phase, and selects a write pulse width and/or a write voltage previous to reception of the second comparison result for the first time as a write pulse width and/or a write voltage for writing the first digital signal in the write phase ⟋ S230

The control circuit receives the second comparison result, controls the ferroelectric memory unit to repeat the write phase and the read phase, gradually increases, until the control circuit receives the first comparison result input by the comparison circuit, the write pulse width and/or the write voltage for writing the first digital signal in the write phase, and selects, as a write pulse width and/or a write voltage for writing the first digital signal in the write phase, a write pulse width and/or a write voltage upon reception of the first comparison result for the first time

S250

FIG. 13

**EP 4 564 353 A1**

<div align="center">

## INTERNATIONAL SEARCH REPORT

</div>

| | |
|---|---|
| | International application No.<br>**PCT/CN2023/105339** |

**A.    CLASSIFICATION OF SUBJECT MATTER**

G11C 11/22(2006.01)i

According to International Patent Classification (IPC) or to both national classification and IPC

**B.    FIELDS SEARCHED**

Minimum documentation searched (classification system followed by classification symbols)

IPC: G11C

Documentation searched other than minimum documentation to the extent that such documents are included in the fields searched

Electronic data base consulted during the international search (name of data base and, where practicable, search terms used)

IEEE, CNKI, DWPI, CNTXT, DWPI, VEN: 铁电, 存储, 比较电路, 控制电路, 写入阶段, 读取阶段, 参考电压, 读电压, 读脉冲, ferroelectric memory, compar+ w circuit, control w circuit, writ+ w stage, read+ w stage, reference, read+ w voltage, read+ w pulse

**C.    DOCUMENTS CONSIDERED TO BE RELEVANT**

| Category* | Citation of document, with indication, where appropriate, of the relevant passages | Relevant to claim No. |
|---|---|---|
| A | CN 111402939 A (ZHUHAI PAIZIJIE INFORMATION TECHNOLOGY CO., LTD.) 10 July 2020 (2020-07-10)<br>claims 1 and 7 | 1-20 |
| A | CN 112885386 A (INSTITUTE OF MICROELECTRONICS OF CHINESE ACADEMY OF SCIENCES) 01 June 2021 (2021-06-01)<br>entire document | 1-20 |
| A | CN 111312309 A (UNIVERSITY OF ELECTRONIC SCIENCE AND TECHNOLOGY OF CHINA) 19 June 2020 (2020-06-19)<br>entire document | 1-20 |
| A | CN 112489705 A (WUXI PETABYTE TECHNOLOGIES CO., LTD.) 12 March 2021 (2021-03-12)<br>entire document | 1-20 |
| A | US 2011058403 A1 (KABUSHIKI KAISHA TOSHIBA) 10 March 2011 (2011-03-10)<br>entire document | 1-20 |

☐ Further documents are listed in the continuation of Box C.        ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **16 October 2023** | **19 October 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/105339**

| Patent document cited in search report | | | Publication date (day/month/year) | Patent family member(s) | | | Publication date (day/month/year) |
|---|---|---|---|---|---|---|---|
| CN | 111402939 | A | 10 July 2020 | None | | | |
| CN | 112885386 | A | 01 June 2021 | None | | | |
| CN | 111312309 | A | 19 June 2020 | None | | | |
| CN | 112489705 | A | 12 March 2021 | None | | | |
| US | 2011058403 | A1 | 10 March 2011 | JP | 2011060342 | A | 24 March 2011 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210921113X, China National Intellectual Property Administration